# EUROPEAN PATENT APPLICATION

(11) **EP 4 579 722 A2**
(43) Date of publication of application: **02.07.2025**
(21) Application number: 25152275.1
(22) Date of filing: 22.08.2023
(51) Int. Cl.: H01L 21/677

(54) **SUBSTRATE PLACEMENT OPTIMIZATION USING SUBSTRATE MEASUREMENTS**

(30) Priority: 24.08.2022 US 202217822009; 23.05.2023 US 202318200921
(62) Divisional of application: 23858008.8
(71) Applicant: Applied Materials, Inc., Santa Clara, CA 95054 (US)
(72) Inventor: Bammanahalli, Gautham Gururaj, Santa Clara (US); Babayan, Steven, Santa Clara (US); Sridharan, Deepak, Santa Clara (US); Li, Haipeng, Santa Clara (US)
(74) Representative: Zimmermann & Partner Patentanwälte mbB

(57) **Abstract**

A computer readable medium includes instructions that, when executed by a processing device, cause the processing device to perform operations. Operations include processing a first substrate in a process chamber while the first substrate is supported by a substrate support at a first placement location. The first substrate includes a first surface profile after processing. Operations further include generating a first surface profile map of the first surface profile using a substrate measurement system. Operations further include determining a plurality of etch rates corresponding to a plurality of locations on the first substrate. Operations further include processing data associated with the plurality of etch rates using a model that is to output one or more estimated surface profiles associated with one or more estimated placement locations. Operations further include determining a recommended placement for substrates on the substrate support based on the one or more estimated placement locations.

## Description

### TECHNICAL FIELD

Embodiments of the present disclosure relate, in general, to optimizing the placement of a substrate in a processing chamber, and in particular to generating a map and/or numerical profiling of a substrate processed using a chamber and optimizing the placement of substrates in the processing chamber based on the map and/or numerical profiling of the substrate.

### BACKGROUND

Substrate processing may include a series of processes that produce electrical circuits in a semiconductor in accordance with a circuit design. These processes may be carried out in a series of process chambers. Successful operation of a modern semiconductor fabrication facility may aim to facilitate a steady stream of wafers to be moved from one chamber to another in the course of forming electrical circuits in the wafer to form a product. In the process of performing many substrate processes, conditions of processing chambers may be altered and may result in a processed substrate failing to meet target conditions and outcomes.

Substrates are placed in the process chambers for processing. Placement of the substrate relative to chamber components can result in varying quality of product produced using the process chambers and/or scrapping of substrates processed using the process chambers.

### SUMMARY

The following is a simplified summary of the disclosure in order to provide a basic understanding of some aspects of the disclosure. This summary is not an extensive overview of the disclosure. It is intended to neither identify key or critical elements of the disclosure, nor delineate any scope of the particular implementations of the disclosure or any scope of the claims. Its sole purpose is to present some concepts of the disclosure in a simplified form as a prelude to the more detailed description that is presented later.

In an exemplary embodiment, a computer readable medium includes instruction that, when executed by a processing device, cause the processing device to perform operations. The operations include processing a first substrate in a process chamber of a substrate processing system while the first substrate is supported by a substrate support at a first placement location on the substrate support. The first substrate includes a first surface profile after the processing. The operations further include generating a first surface profile map of the first surface profile using a substrate measurement system. The operations further include determining a first plurality of etch rates corresponding to a first plurality of locations on the first substrate based on the first surface profile map. The operations further include processing data associated with the first plurality of etch rates using a model. The model is to output one or more estimated surface profiles associated with one or more estimated placement locations on the substrate support based on the first plurality of etch rates. The operations further include determining a recommended placement for substrates on the substrate support based on the one or more estimated placement locations.

In an exemplary embodiment, a system includes a process chamber including a substrate support. The system further includes a substrate measurement tool, a memory, and a processing device operatively coupled to the memory. The processing device is to cause a first substrate to be processed in the process chamber while the first substrate is supported by the substrate support at a first placement location on the substrate support. The first substrate includes a first surface profile after the processing. The processing device is further to generate a first surface profile map of the first surface profile using the substrate measurement tool. The processing device is further to determine a first plurality of etch rates corresponding to a first plurality of locations on the first substrate based on the first surface profile map. The processing device is further to process data associated with the first plurality of etch rates using a model. The model is to output one or more estimated surface profiles associated with one or more estimated placement locations on the substrate support based on the first plurality of etch rates. The processing device is further to determine a recommended placement for substrates on the substrate support based on the one or more estimated placement locations.

In an exemplary embodiment, a method includes causing a first substrate to be processed in a process chamber while the first substrate is supported by a substrate support at a first placement location on the substrate support. The first substrate includes a first surface profile after the processing. The method further includes generating a first surface profile map of the first surface profile using a substrate measurement system. The method further includes determining a first plurality of etch rates corresponding to a first plurality of locations on the first substrate based on the first surface profile map. The method further includes processing data associated with the first plurality of etch rates using a model. The model is to output one or more estimated surface profiles associated with one or more estimated placement locations on the substrate support based on the first plurality of etch rates. The method further includes determining a recommended placement for substrates on the substrate support based on the one or more estimated placement locations.

### BRIEF DESCRIPTION OF THE DRAWINGS

The present disclosure is illustrated by way of example, and not by way of limitation, in the figures of the accompanying drawings in which like references indicate similar elements. It should be noted that different references to "an" or "one" embodiment in this disclosure are not necessarily to the same embodiment, and such references mean at least one.
**FIG. 1** depicts an illustrative computer system architecture, according to aspects of the present disclosure.
**FIG. 2A** is a top schematic view of an example manufacturing system, according to aspects of the present disclosure.
**FIG. 2B** is a cross-sectional schematic side view of a substrate measurement system included in the example manufacturing system of FIG. 2A, according to aspects of the present disclosure.
**FIG. 2C** is a cross-sectional schematic side view of a substrate measurement subsystem, according to aspects of the present disclosure.
**FIG. 3** depicts an illustrative system architecture for substrate placement prediction for a processing chamber, according to aspects of the present disclosure.
**FIG. 4** illustrates a model training workflow and a model application workflow for substrate placement determination, according to one embodiment.
**FIG. 5** is a flow chart of a method for generating a training dataset for training a machine learning model, according to aspects of the present disclosure.
**FIG. 6** illustrates a flow diagram for a method of training a machine learning model to determine a substrate placement, in accordance with one embodiment.
**FIG. 7** is a flow diagram for a method of determining a recommended substrate placement, according to aspects of the present disclosure.
**FIG. 8** is a flow diagram for a method of comparing a second estimated substrate placement with a first estimated substrate placement, according to aspects of the present disclosure.
**FIG. 9** is a profile map (e.g., a heat map) of a processed substrate, according to aspects of the present disclosure.
**FIGS. 10A-10B** are flow diagrams for methods of determining optimal substrate placement, according to aspects of the present disclosure.
**FIG. 11A** is an example plot diagram of a substrate placement design of experiments, according to aspects of the present disclosure.
**FIG. 11B** is an example radial plot of substrate etch rates with respect to theta, according to aspects of the present disclosure.
**FIG. 12A** is an example plot of substrate etch rates with respect to theta, according to aspects of the present disclosure.
**FIG. 12B** is an example plot of normalized substrate etch rates with respect to theta, according to aspects of the present disclosure.
**FIG. 13A** is an example plot of normalized substrate etch rates of a substrate placement design of experiments, according to aspects of the present disclosure.
**FIG. 13B** is an example plot diagram of a substrate design of experiments, according to aspects of the present disclosure.
**FIG. 13C** is an example plot of a linear fit for substrate etch rates, according to aspects of the present disclosure.
**FIG. 14** is a flow diagram for a method of determining an optimal substrate placement, according to aspects of the present disclosure.
**FIG. 15** depicts a diagrammatic representation of a machine in the example form of a computing device within which a set of instructions, for causing the machine to perform any one or more of the methodologies discussed herein, can be executed.

### DETAILED DESCRIPTION OF EMBODIMENTS

Embodiments of the present disclosure are directed to a system and method for optimizing substrate placement in a process chamber using substrate measurements. Process results of manufacturing processes depend on many factors, including process recipe, chamber parameter settings, chamber component conditions, and substrate placement within the process chamber. For example, process results may vary across the surface of a substrate based on a placement of the substrate relative to a process kit ring. The gap between the edge of the substrate and the process kit ring is often related to effects of the substrate processing proximate the edge of the substrate. Additionally, process results may vary across the surface of a substrate based on a condition of a showerhead, a condition of a substrate support that supports the substrate, a condition of a chamber liner, conditions of pumps and/or valves, and so on. The optimized placement of the substrate can be affected by the conditions of the process chamber components described herein. For example, any changes to a substrate support such as an electrostatic chuck, a clamp, a vacuum chuck, a heater, a support that includes a pocket with a lip on an edge of the support, and/or substrate support that includes one or more embedded features (e.g., such as a heater, cooling plate, electrical elements, etc.) and so on over time will slowly impact substrate results, such as through temperature change across a surface of a processed substrate, a radiofrequency (RF) field at an edge of the substrate, and so on. These impacts to substrate results will slowly impact the optimized substrate placement for the best process results. Thus, over time, the optimal placement of the substrate on the substrate support may have a tendency to change.

Substrate results may be particularly affected by substrate placement proximate the edge of the processed substrate. For example, factors that contribute to substrate etch rate (e.g., temperature, gas flow, etc.) may cause tilt near the edge of the processed substrate. "Tilt" refers to the tendency of substrate features (e.g., valleys, walls, pillars, mesas, etc.) to not be orthogonal to the substrate surface. Excessive tilt can lead to a substrate having a low quality and/or being scrapped. Tilt often affects the substrate near the edge of the substrate, and particularly near the extreme edge of the substrate (e.g., within five millimeters of the substrate edge). Changes in the substrate placement relative to components of the substrate support (e.g., a process kit ring, etc.) may impact the processing of the substrate. For example, variances in the gap between the edge of the substrate and a process kit ring (e.g., the gap that surrounds the wafer) can lead to more than a threshold amount of allowable tilt, causing the substrate to be scrapped.

Embodiments described herein provide mechanisms for determining optimized placement of substrates for processing in a process chamber. Some embodiments can be used to determine a recommended position for substrates on a substrate support for processing in the process chamber. The recommended position can be used to determine an offset for a substrate-handling robot (e.g., a transfer chamber robot, etc.) to place substrates in the process chamber.

In some embodiments, a substrate is processed in a process chamber according to a recipe. The substrate may be processed to deposit or etch a film layer and/or one or more features (e.g., measureable features) on a surface of the substrate. The substrate may be a bare substrate or a test substrate that does not include product. Alternatively, the substrate may be a product substrate. The features may include features distributed across a surface of the substrate, such as mesas, dots, structures, valleys, walls, lines, trenches, grooves, fiducials, and so on. The substrate may be supported by a substrate support of the process chamber (e.g., an electrostatic chuck, etc.) during the processing, in some examples. In some examples, after the processing, the substrate may have a surface profile (e.g., a thickness profile, a tilt profile, etc.). In the example of an etch process recipe, the surface profile may be indicative of etch rates across the surface of the substrate (e.g., an etch rate profile) during the etch processing. In some examples, etch rate may be correlated to tilt, especially at locations on the substrate surface proximate the edge of the substrate.

After the film and/or feature has been deposited or etched on the substrate, in some embodiments, the substrate may be removed from the process chamber and input into a substrate measurement system. In some embodiments, a profile map of the substrate is generated based on the surface profile of the substrate by the substrate measurement system. The substrate measurement system may be, for example, a reflectometry system or other measurement system that measures a film thickness of the film and/or feature(s) at multiple locations of the substrate. The thickness information may be used to generate the profile map for the substrate. Alternatively, one or more other profile maps (e.g., of optical constants, or roughness, of particle counts, etc.) of the substrate may be generated from other measurement data.

The film and/or feature thickness information (e.g., thickness profile map) or other film and/or feature information (e.g., other profile maps such as an optical constant profile map, a particle count profile map, etc.) may then be processed using a model (e.g., a trained machine learning model, a physics-based model, a statistical model, and/or image processor, etc.) to identify variations in the film property or properties. The model may output an estimated substrate placement value for placement of the substrate relative to one or more components in the process chamber (e.g., electrostatic chuck, process kit ring, etc.). In embodiments, the model may output a recommended placement position for substrates, may output one or more predicted film properties associated with the recommended placement position (e.g., a predicted profile map of substrates processed from the recommended placement position), and so on.

In some embodiments, etch rates at multiple locations on the surface of the substrate are determined from the feature thickness information. In some embodiments, data associated with the etch rates may be processed using a model to determine an estimated placement location for the substrate on the substrate support for processing. For example, normalized etch rates for a number of test substrates (each test substrate processed at a different substrate placement) at a specified location on each of the substrates can be processed by a numerical model to determine the effects of different substrate placements. The model may output an estimated substrate placement and/or an estimated substrate placement value relative to one or more components in the process chamber.

In some embodiments, a recommended placement for substrates on the substrate support is determined based on the estimated substrate placement value. In some examples, the recommended placement is an optimized placement location on the substrate support (e.g., electrostatic chuck, etc.) for processing substrates to meet target substrate specifications (e.g., having less than a threshold amount of tilt proximate the substrate edge, etc.). In some examples, the optimized location of substrates on the substrate support is such that a uniform gap exists around the substrate between the edge of the substrate and the inner diameter of the process kit ring. However, in some examples, the optimized location of substrates does not provide a uniform gap. In such examples, the optimized location of substrates accounts for process chamber variables such as the condition of one or more chamber components (e.g., process kit ring condition, showerhead condition, electrostatic chuck condition, etc.). In some embodiments, robot arm settings are determined for placing substrates at the recommended placement location, and those settings are used for placing substrates onto the substrate support.

Accordingly, embodiments described herein add new detection capabilities to process chambers without any increased cost for those process chambers. These new detection capabilities can be leveraged in some embodiments to increase quality and/or quantity of processed substrates that meet a threshold specification (e.g., a threshold tilt specification for the processed substrates, etc.). Additionally, or alternatively, the embodiments described herein can be used to decrease an amount of scrapped product (e.g., scrapped substrates) due to the scrapped product not meeting the threshold specification. The embodiments described herein can be used to automatically optimize certain process variables (e.g., substrate placement during processing) to quickly and more-efficiently process substrates of increasing quality when compared to conventional substrate processing systems. Particularly, the embodiments described herein can be used to produce substrates having better edge properties (e.g., tilt, etc.) when compared to substrates produced by conventional systems. This, again, leads to higher quality substrates, less scrapped product, and so on.

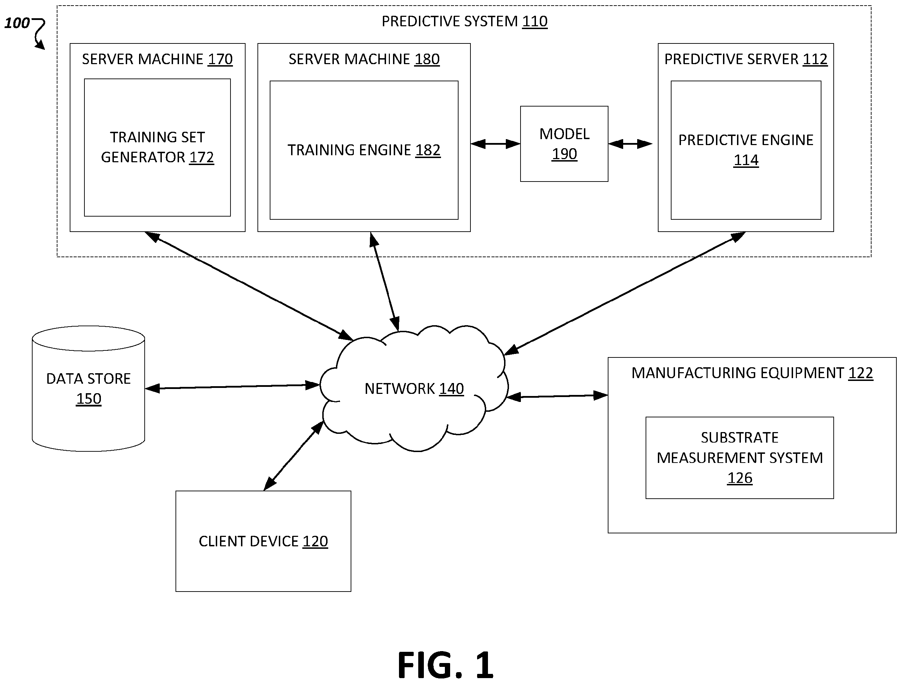

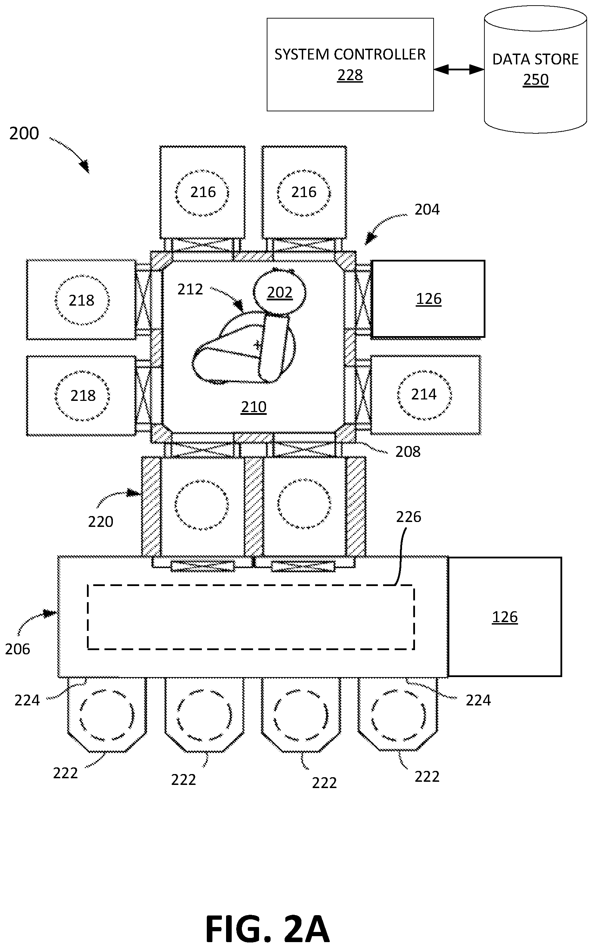

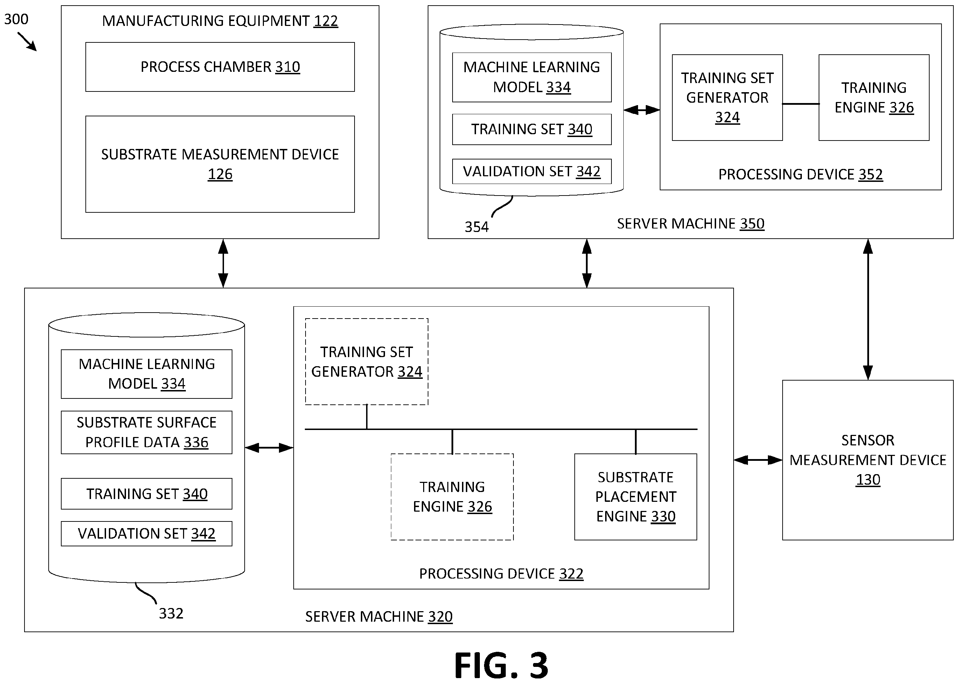

**FIG. 1** depicts an illustrative computer system architecture 100, according to aspects of the present disclosure. Computer system architecture 100 includes a client device 120, manufacturing equipment 122, substrate measurement system 126, a predictive server 112 (e.g., to generate predictive data, to provide model adaptation, to use a knowledge base, etc.), and a data store 150. The predictive server 112 can be part of a predictive system 110. The predictive system 110 can further include server machines 170 and 180. In some embodiments, computer system architecture 100 can include or be a part of a manufacturing system for processing substrates, such as manufacturing system 200 of FIG. 2A. In additional or alternative embodiments, computer system architecture 100 can include or be a part of a substrate placement prediction system (e.g., that assesses conditions of one or more chamber components in a process chambers). Further details regarding the substrate placement prediction system are provided with respect to FIGS. 3-4.

Components of the client device 120, manufacturing equipment 122, substrate measurement system 126, predictive system 110, and/or data store 150 can be coupled to each other via a network 140. In some embodiments, network 140 is a public network that provides client device 120 with access to predictive server 112, data store 150, and other publicly available computing devices. In some embodiments, network 140 is a private network that provides client device 120 access to manufacturing equipment 122, substrate measurement system 126, data store 150, and/or other privately available computing devices. Network 140 can include one or more wide area networks (WANs), local area networks (LANs), wired networks (e.g., Ethernet network), wireless networks (e.g., an 802.11 network or a Wi-Fi network), cellular networks (e.g., a Long Term Evolution (LTE) network), routers, hubs, switches, server computers, cloud computing networks, and/or a combination thereof.

The client device 120 can include a computing device such as personal computers (PCs), laptops, mobile phones, smart phones, tablet computers, netbook computers, network connected televisions ("smart TVs"), network-connected media players (e.g., Blu-ray player), a set-top box, over-the-top (OTT) streaming devices, operator boxes, etc.

Manufacturing equipment 122 can produce products following a recipe. In some embodiments, manufacturing equipment 122 can include or be a part of a manufacturing system that includes one or more stations (e.g., process chambers, transfer chamber, load lock, factory interface, etc.) configured to perform different operations for a substrate.

Substrate measurement system 126 may be a component of a manufacturing system that can be used to measure substrates before and/or after those substrates are processed in one or more process chambers. The substrate measurement system 126 may be configured to generate optical emission spectroscopy data, reflectometry data, and/or other metrology data. The substrate measurement system 126 can include one or more components configured to collect and/or generate measurement data associated with one or more portions of a profile of a surface of a substrate after the substrate has been removed from a process chamber.

In some embodiments, substrate measurement system 126 can be configured to generate metrology data associated with substrates processed by other manufacturing equipment 122. The metrology data can include a value of one or more of film property data (e.g., wafer spatial film properties such as thickness), dimensions (e.g., thickness, height, etc.), dielectric constant, dopant concentration, density, defects, etc. The metrology data can be of a finished or semi-finished product, or of a test substrate such as a blanket wafer. Some embodiments are discussed with reference to use of reflectometry data and thickness profile maps to determine conditions of chamber components. However, it should be understood that the principles and embodiments set forth herein in association with reflectometry data and thickness profile maps also applies to other type of metrology data. For example, measurements may be made of particle counts, of optical constants for coatings, of surface roughness of coatings, of material compositions of coatings, and so on. Such measurements may be made for many regions on a substrate, and may be used to generate profile maps of particle counts, of optical constants, of surface roughness, of material composition, and so on across a measured substrate.

Substrate measurement system 126 can be configured to generate metrology data associated with a substrate before and/or after a substrate process. Substrate measurement system 126 can be integrated with a station of the manufacturing system that includes manufacturing equipment 122. In some embodiments, substrate measurement system 126 can be coupled to or be a part of a station of the process tool that is maintained under a vacuum environment (e.g., a process chamber, a transfer chamber, etc.). Such substrate measurement system 126 may be referred to as on-board metrology equipment. Accordingly, the substrate can be measured by the substrate measurement system 126 while the substrate is in the vacuum environment. For example, after a substrate process (e.g., an etch process, a deposition process, etc.) is performed for the substrate, the metrology data for the processed substrate can be generated by substrate measurement system 126 without the processed substrate being removed from the vacuum environment. In other or similar embodiments, substrate measurement system 126 can be coupled to or be a part of a manufacturing system that is not maintained under a vacuum environment (e.g., a factory interface module, etc.). Such substrate measurement system 126 may be referred to as on-board metrology equipment.

Alternatively to substrate measurement system 126 being included in a manufacturing system (e.g., attached to a factory interface or transfer chamber), substrate measurement system 126 may be a device that is separate from (i.e., external to) manufacturing equipment 122. For example, substrate measurement system 126 can be standalone equipment that is not coupled to any station of manufacturing equipment 122. For a measurement to be obtained for a substrate using a detached substrate measurement system 126, a user of a manufacturing system (e.g., an engineer, an operator) can cause a substrate processed at manufacturing equipment 122 to be removed from manufacturing equipment 122 and transferred to substrate measurement system 126 for measurement. In some embodiments, substrate measurement system 126 can transfer metrology data generated for the substrate to the client device 120 coupled to substrate measurement system 126 via network 140 (e.g., for presentation to a manufacturing user, such as an operator or an engineer). In other or similar embodiments, the manufacturing system user can obtain metrology data for the substrate from substrate measurement system 126 and can provide the metrology data to computer system architecture via a graphical user interface (GUI) of client device 120.

Data store 150 can be a memory (e.g., random access memory), a drive (e.g., a hard drive, a flash drive), a database system, or another type of component or device capable of storing data. Data store 150 can include multiple storage components (e.g., multiple drives or multiple databases) that can span multiple computing devices (e.g., multiple server computers). The data store 150 can store profile maps (e.g., as generated from reflectometry data, from spectra data, etc.) such as film thickness profile maps and/or other substrate profile maps. Film thickness profile maps and/or other substrate profile maps can include historical maps and/or current maps.

One or more portions of data store 150 can be configured to store data that is not accessible to a user of the manufacturing system. In some embodiments, all data stored at data store 150 can be inaccessible by the manufacturing system user. In other or similar embodiments, a portion of data stored at data store 150 is inaccessible by the user while another portion of data stored at data store 150 is accessible to the user. In some embodiments, inaccessible data stored at data store 150 is encrypted using an encryption mechanism that is unknown to the user (e.g., data is encrypted using a private encryption key). In other or similar embodiments, data store 150 can include multiple data stores where data that is inaccessible to the user is stored in a first data store and data that is accessible to the user is stored in a second data store.

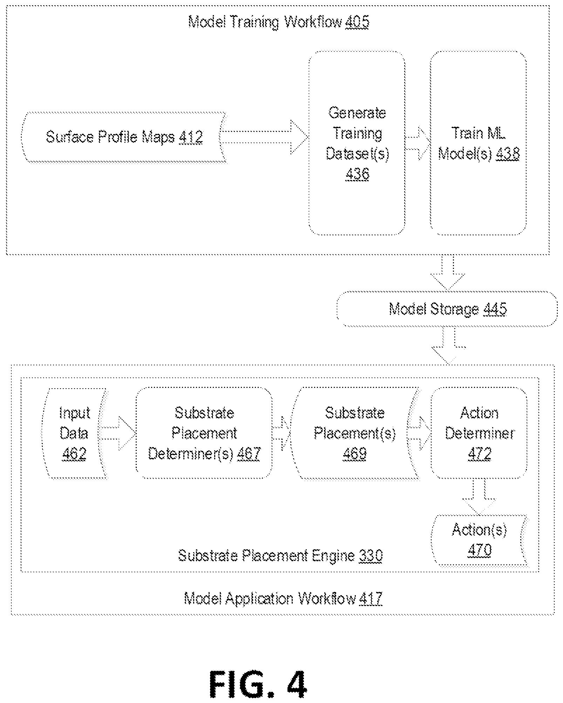

In some embodiments, predictive system 110 includes server machine 170 and server machine 180. Server machine 170 includes a training set generator 172 that is capable of generating training data sets (e.g., a set of data inputs and a set of target outputs) to train, validate, and/or test a machine learning model 190 or set of machine learning models 190. Some operations of training set generator 172 are described in detail below with respect to **FIG. 4****.** In some embodiments, the training set generator 172 can partition the training data into a training set, a validating set, and a testing set.

Server machine 180 can include a training engine 182. An engine can refer to hardware (e.g., circuitry, dedicated logic, programmable logic, microcode, processing device, etc.), software (such as instructions run on a processing device, a general purpose computer system, or a dedicated machine), firmware, microcode, or a combination thereof. Training engine 182 can be capable of training a machine learning model 190 or a set of machine learning models 190. The machine learning model 190 can refer to the model artifact that is created by the training engine 182 using the training data that includes training inputs and corresponding target outputs (correct answers for respective training inputs). The training engine 182 can find patterns in the training data that map the training input to the target output (the answer to be predicted), and provide the machine learning model 190 that captures these patterns. The machine learning model 190 can include a linear regression model, a partial least squares regression model, a Gaussian regression model, a random forest model, a support vector machine model, a neural network, a ridge regression model, and so forth.

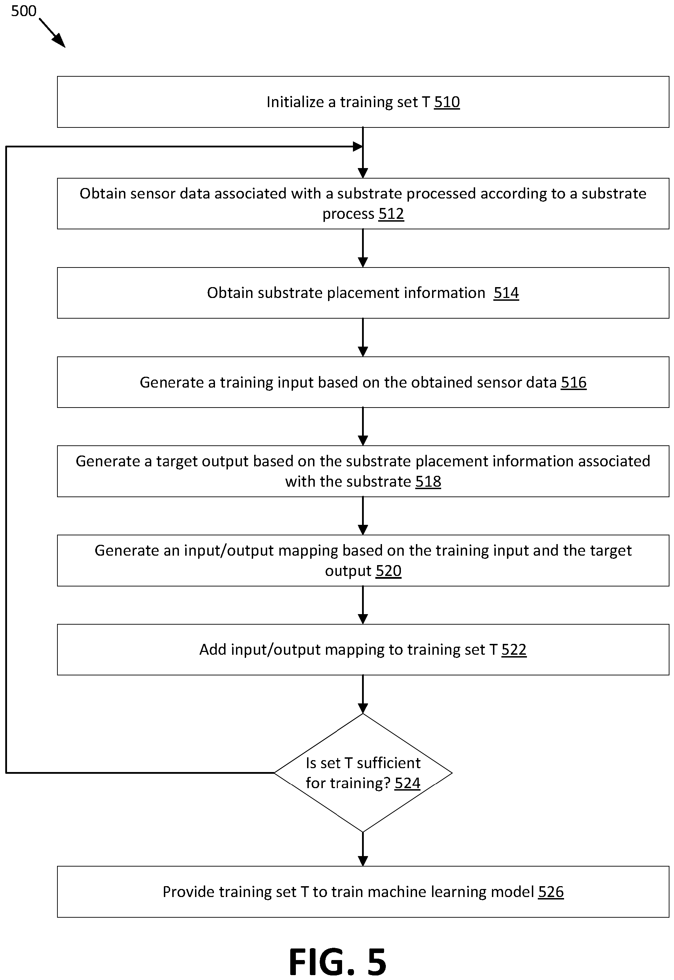

Training engine 182 can also be capable of validating a trained machine learning model 190 using a corresponding set of features of a validation set from training set generator 172. In some embodiments, training engine 182 can assign a performance rating for each of a set of trained machine learning models 190. A performance rating can correspond to an accuracy of a respective trained model, a speed of the respective model, and/or an efficiency of the respective model. Training engine 182 can select a trained machine learning model 190 having a performance rating that satisfies a performance criterion to be used by predictive engine 114, in accordance with embodiments described herein. Further details regarding training engine 182 are provided with respect to **FIG. 5****.**

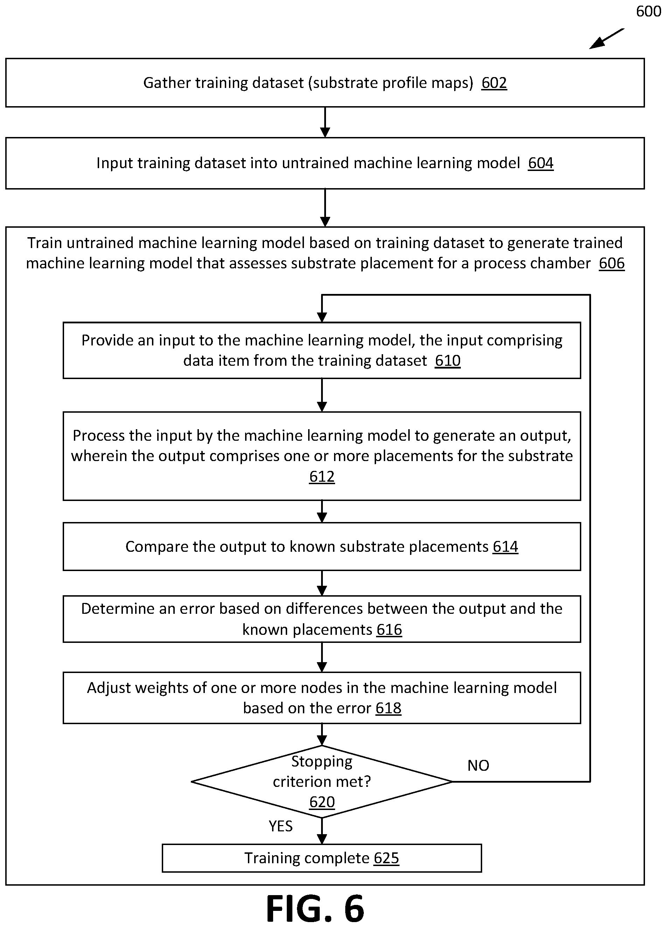

Predictive server 112 includes a predictive engine 114 that is capable of providing data from substrate measurement system 126 (e.g., a film thickness profile map) as input to trained machine learning model 190 and running trained model 190 on the input to obtain one or more outputs. In some embodiments, trained model 190 run by predictive engine 114 is selected by training engine 182 as having a performance rating that satisfies a performance criterion. As described further with respect to **FIG. 6****,** in some embodiments, predictive engine 114 processes input data using model 190 to assess substrate placement for processing substrates in a process chamber.

It should be noted that in some other implementations, the functions of server machines 170 and 180, as well as predictive server 112, can be provided by a larger or smaller number of machines. For example, in some embodiments, server machines 170 and 180 can be integrated into a single machine, while in some other or similar embodiments, server machines 170 and 180, as well as predictive server 112, can be integrated into a single machine. In general, functions described in one implementation as being performed by server machine 170, server machine 180, and/or predictive server 112 can also be performed on client device 120. In addition, the functionality attributed to a particular component can be performed by different or multiple components operating together.

In embodiments, a "user" can be represented as a single individual. However, other embodiments of the disclosure encompass a "user" being an entity controlled by a plurality of users and/or an automated source. For example, a set of individual users federated as a group of administrators can be considered a "user."

**FIG. 2A** is a top schematic view of an example manufacturing system 200, according to aspects of the present disclosure. Manufacturing system 200 can perform one or more processes on a substrate 202. Substrate 202 can be any suitably rigid, fixed-dimension, planar article, such as, e.g., a silicon-containing disc or wafer, a patterned wafer, a glass plate, or the like, suitable for fabricating electronic devices or circuit components thereon, according to aspects of the present disclosure. In some embodiments, manufacturing system 200 can be include or be a part of computer system architecture 110, in accordance with embodiments described with respect to **FIG. 1****.**

Manufacturing system 200 can include a process tool 204 and a factory interface 206 coupled to process tool 204. Process tool 204 can include a housing 208 having a transfer chamber 210 therein. Transfer chamber 210 can include one or more processing chambers (also referred to as process chambers) 214, 216, 218 disposed therearound and coupled thereto. Processing chambers 214, 216, 218 can be coupled to transfer chamber 210 through respective ports, such as slit valves or the like. Transfer chamber 210 can also include a transfer chamber robot 212 configured to transfer substrate 202 between process chambers 214, 216, 218, load lock 220, etc. Transfer chamber robot 212 can include one or multiple arms where each arm includes one or more end effectors at the end of each arm. The end effector can be configured to handle particular objects, such as wafers.

In some embodiments, transfer chamber 210 can also include metrology equipment, such as substrate measurement system 126 attached thereto. Substrate measurement system 126 can be configured to generate metrology data associated with substrate 202 before or after a substrate process, while the substrate is maintained in a vacuum environment. As illustrated in **FIG. 2A****,** substrate measurement system 126 can be attached to transfer chamber 210 or disposed within transfer chamber 210. If substrate measurement system 126 is disposed within or coupled to transfer chamber 210, metrology data associated with substrate 202 can be generated without substrate 202 being removed from the vacuum environment (e.g., transferred to factory interface 206).

Process chambers 214, 216, 218 can be adapted to carry out any number of processes on substrates 202. A same or different substrate process can take place in each processing chamber 214, 216, 218. A substrate process can include atomic layer deposition (ALD), physical vapor deposition (PVD), chemical vapor deposition (CVD), etching, annealing, curing, pre-cleaning, metal or metal oxide removal, or the like. Other processes can be carried out on substrates therein.

A load lock 220 can also be coupled to housing 208 and transfer chamber 210. Load lock 220 can be configured to interface with, and be coupled to, transfer chamber 210 on one side and factory interface 206 on another side. Load lock 220 can have an environmentally-controlled atmosphere that can be changed from a vacuum environment (wherein substrates can be transferred to and from transfer chamber 210) to an atmospheric-pressure (or near atmospheric-pressure) inert-gas environment (wherein substrates can be transferred to and from factory interface 206), in some embodiments.

Factory interface 206 can be any suitable enclosure, such as an Equipment Front End Module (EFEM). Factory interface 206 can be configured to receive substrates 202 from substrate carriers 222 (e.g., Front Opening Unified Pods (FOUPs)) docked at various load ports 224 of factory interface 206. A factory interface robot 226 (shown dotted) can be configured to transfer substrates 202 between substrate carriers 222 (also referred to as containers) and load lock 220. In other and/or similar embodiments, factory interface 206 can be configured to receive replacement parts from replacement parts storage containers.

In some embodiments, manufacturing system 200 can include substrate measurement system 126 attached to factory interface 206. Substrate measurement system 126 attached to factory interface can be configured to generate metrology data associated with substrate 202 prior to substrate 202 being placed in the vacuum environment (e.g., transferred to load lock 220) and/or after substrate 202 is removed from the vacuum environment (e.g., removed from load lock 220).

Manufacturing system 200 can also be connected to a client device (e.g., client device 120 of **FIG. 1**) that is configured to provide information regarding manufacturing system 200 to a user (e.g., an operator). In some embodiments, the client device can provide information to a user of manufacturing system 200 via one or more graphical user interfaces (GUIs). For example, the client device can provide information regarding one or more chamber condition metrics (e.g. while performing a substrate process) of a processing chamber 214, 216, 218 via a GUI.

Manufacturing system 200 can also include or be coupled to a system controller 228. System controller 228 can be and/or include a computing device such as a personal computer, a server computer, a programmable logic controller (PLC), a microcontroller, and so on. System controller 228 can include one or more processing devices, which can be general-purpose processing devices such as a microprocessor, central processing unit, or the like. More particularly, the processing device can be a complex instruction set computing (CISC) microprocessor, reduced instruction set computing (RISC) microprocessor, very long instruction word (VLIW) microprocessor, or a processor implementing other instruction sets or processors implementing a combination of instruction sets. The processing device can also be one or more special-purpose processing devices such as an application specific integrated circuit (ASIC), a field programmable gate array (FPGA), a digital signal processor (DSP), network processor, or the like. System controller 228 can include a data storage device (e.g., one or more disk drives and/or solid state drives), a main memory, a static memory, a network interface, and/or other components. System controller 228 can execute instructions to perform any one or more of the methodologies and/or embodiments described herein. In some embodiments, system controller 228 can execute instructions to perform one or more operations at manufacturing system 200 in accordance with a process recipe. The instructions can be stored on a computer readable storage medium, which can include the main memory, static memory, secondary storage and/or processing device (during execution of the instructions).

In some embodiments, system controller 228 can receive data from substrate measurement system 126 based on measurement of a substrate that has undergone processing by a process chamber 214, 216, 218. Data received by the system controller 228 can include spectral data, reflectometry data and/or other data for all or a portion of substrate 202. Data received from substrate measurement system 126 can be stored in a data store 250. Data store 250 can be included as a component within system controller 228 or can be a separate component from system controller 228. In some embodiments, data store 250 can be or include a portion of data store 150, as described with respect to **FIG. 1****.**

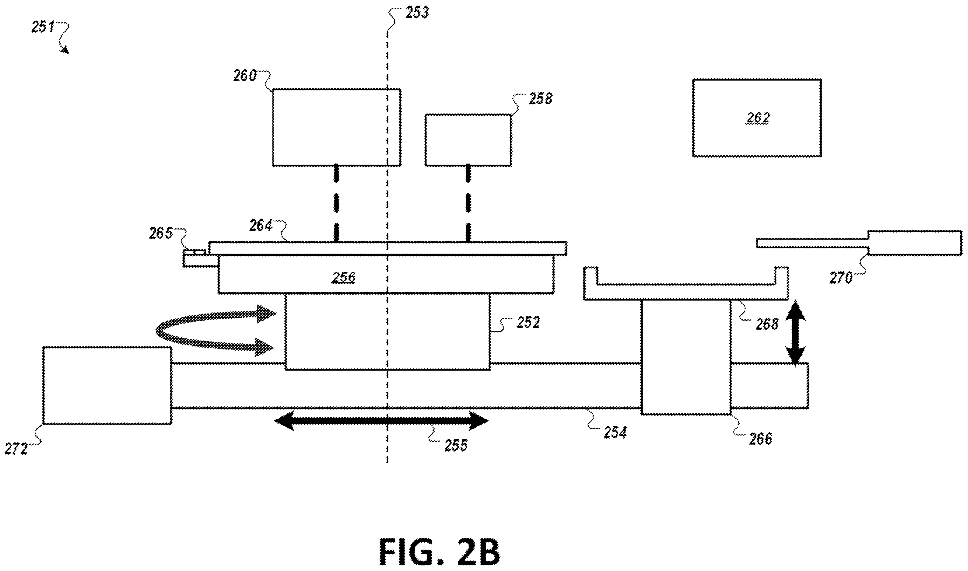

**FIG. 2B** illustrates one embodiment of a substrate measurement system 251 that may be used to measure processed substrates. Substrate measurement system 251 may be an integrated measurement and/or imaging system (e.g., integrated reflectometry (IR) system) configured for measuring film properties (e.g., such as thickness) across a surface of a substrate 264 after the substrate 264 is processed in a processing chamber. Reflectometry is a measurement technique that uses measured changes in light reflected from an object to determine geometric and/or material properties of the object. Reflectance spectrometers measure the intensity of reflected light across a range of wavelengths. For dielectric films these intensity variations may be used to determine the thickness of the film.

Process results, including film thicknesses, can be monitored across one or more substrates for etch and deposition processes using substrate measurement system 251, for example. The integrated measurement and/or imaging system may be used to measure a surface of a substrate 264 while the substrate 264 is still in the device manufacturing system. Substrate measurement system 251 may correspond to substrate measurement system 126 in some embodiments. Substrate measurement system 251 may be connected to a factory interface or to a transfer chamber. Alternatively, the substrate measurement system 251 may be positioned in an interior of the factory interface or transfer chamber. Substrate measurement system 251 may also be a standalone system that is not connected to a manufacturing system. Substrate measurement system 251 may be mechanically isolated from a factory interface and from an external environment to protect substrate measurement system 251 from external vibrations. In some embodiments, substrate measurement system 251 and its contained components may provide analytical measurements (e.g., thickness measurements) that may provide a uniformity profile across a surface of a substrate 264, referred to herein as a profile map. A computing device may process that data from substrate measurement system 251 and provide feedback to a user. Substrate measurement system 251 may be an assembly that has the ability to measure film thicknesses and/or other film properties such as optical constants, particle counts, roughness, etc. across a portion of a substrate or an entire substrate after it has been processed in a chamber. The results of the measurements may be used to determine when to perform maintenance on a process chamber, when to perform further testing on a substrate, when to flag a substrate as being out-of-specification, placement of a substrate during substrate processing, and so on.

When the substrate 264 is lowered onto and secured to a substrate support 256 (e.g., a chuck), the center of the substrate 264 may be offset from the center of the chuck. A processing device of substrate measurement system 251 may determine one or more coordinate transformations between the center of the substrate 264 and the center of the chuck (the center of the chuck corresponds to the axis of rotation about which the chuck rotates) 256, and apply the one or more coordinate transformations to correct the offset, as described in greater detail below.

Substrate measurement system 251 may include a rotational actuator 252 and a linear actuator 254. Rotational actuator 252 may be a motor, a rotary actuator (e.g., an electric rotary actuator), or the like. Linear actuator 254 may be an electric linear actuator, which may convert rotational motion in motors into linear or straight motions along an axis. Substrate measurement system 251 may include a substrate support 256, a camera 258, a sensor 260, and a processing device 262.

Substrate support 256 may be a vacuum chuck, an electrostatic chuck, a magnetic chuck, a mechanical chuck (e.g., a four jaw chuck, a three jaw chuck, an edge/ring clamp chuck, etc.) or other type of chuck. Substrate support 256 may secure a substrate 264 (e.g., a wafer). Rotational actuator 252 may rotate substrate support 256 about a first axis 253. Rotational actuator 252 may be controlled by a servo controller and/or servomotor, which may allow for precise control of a rotational position, velocity and/or acceleration of the rotational actuator and thus of substrate support 256. Linear actuator 254 may move substrate support 256 linearly along a second axis 255. Linear actuator 254 may be controlled by a servo controller and/or servomotor 272, which may allow for precise control of a linear position, velocity, and acceleration of linear actuator 254, and thus of substrate support 256.

Camera 258 may be positioned above substrate support 256, and may generate one or more images of substrate 264 held by substrate support 256. Camera 258 may be an optical camera, an infrared camera, or other suitable type of camera. A sensor 260 may also be positioned above substrate support 256, and may measure at least one target position on the substrate at a time (e.g., may generate a reflectometry measurement or other measurement of the target position). Camera 258 and sensor 260 may be fixed in a stationary position on substrate measurement system 251, while substrate support 256 may be moved in an r-theta motion by rotation actuator 252 and linear actuator 254.

In some embodiments, processing device 262 may determine, based on the one or more images of substrate 264 generated by camera 258, that substrate 264 is not centered on substrate support 256. Substrate 264 may be not centered on substrate support 256 when it is initially placed on substrate support 256. A robot blade 270 may place substrate 264 on a transfer station 268 (e.g., a set of lift pins). Substrate support 256 may be moved in a first direction along second axis 255 such that substrate support 256 is positioned at transfer station 268. Transfer station 268 may be situated on a lift mechanism 266 (or may be a set of lift pins), which may move transfer station 268 up and down in a vertical direction (that is perpendicular to second axis 255 and parallel to first axis 253). Substrate 264 may be received by substrate support 256 while substrate support 256 is positioned at transfer station 268. Substrate 264 may not be centered on substrate support 256. Substrate support 256 may be moved in a second direction along second axis 255 until an edge of substrate 264 is detected to be at a target position by sensor 260.

The substrate support may be rotated 360 degrees, and images may be generated during the rotation of the substrate support. One or more of the measurements and/or images may be taken with the chuck at various different theta values, and the detected location of the edge may vary. A change in the detected edge may indicate that the substrate (which may be a circular substrate) is off center. Additionally, the determined change in the detected edge may be used to compute the amount of offset.

In one embodiment, the parameters (r, theta) determine the offset of the substrate relative to the stage. With these parameters, the motion system can create forward and inverse transformations that converts (r, theta) coordinates of the stage to (r, theta) coordinates of the substrate. The motion system can then compute trajectories in the space of the substrate while sending commands to move the motors attached to the substrate support 256. In one embodiment, the motion system can compute trajectories in an arbitrary space because it runs a real-time control software that is connected to the motion drives of the linear actuator and the rotational actuator (e.g., through an EtherCAT network). Processing device 262 may compute the corrected trajectory and transmit commanded positions to the motion drives in real-time (e.g., at a 1 kHz rate).

In some embodiments, the rotation of substrate support 256 by rotational actuator 252 for measurement of a target position causes an offset between a field of view of sensor 260 and the target position on substrate 264 due to substrate 264 not being centered on substrate support 256. In this case, linear actuator 254 may move substrate support 256 linearly along the second axis to correct the offset. Then, sensor 260 may measure target positions on substrate 264. Once measurements of all target points on the substrate are measured, processing device 262 may determine a uniformity profile across the surface of substrate 264 based on the measurements.

In some embodiments, processing device 262 may determine one or more coordinate transformations between a center of substrate support 256 (corresponding to first axis 253 about which substrate support 256 rotates) and a center of substrate 264 that are applied during the rotation of substrate support 256 to correct for the offset.

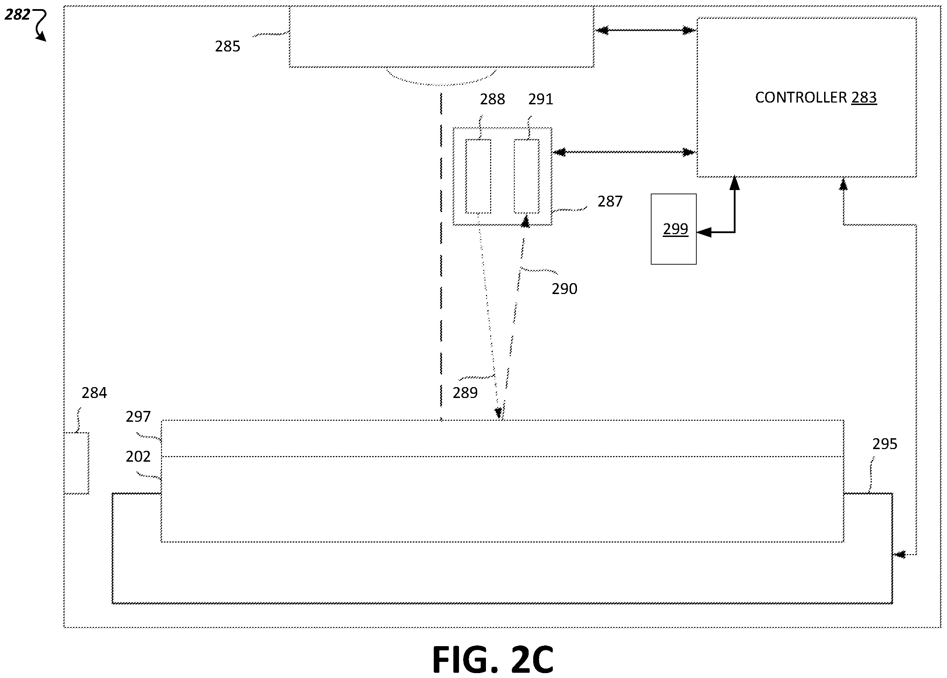

**FIG. 2C** is a cross-sectional schematic side view of a substrate measurement subsystem 282, according to aspects of the present disclosure. Substrate measurement subsystem 282 may be configured to obtain measurements for one or more portions of a substrate, such as substrate 202 of **FIG. 2A****,** prior to or after processing of substrate 202 at a processing chamber. Substrate measurement subsystem 282 may correspond to substrate measurement system 126 of FIG. 2A in embodiments. Substrate measurement subsystem 282 may obtain measurements for a portion of substrate 202 by generating data associated with the portion of substrate 202. In some embodiments, substrate measurement subsystem 282 may be configured to generate spectral data, positional data, and/or other property data associated with substrate 202.

The substrate measurement subsystem 282 may be configured to generate one or more types of data for the substrate, including spectral data, positional data, substrate property data, etc. The substrate measurement subsystem 282 can generate the data for the substrate in response to a request to obtain one or more measurements for the substrate before or after the substrate is processed at the manufacturing system. The substrate measurement subsystem 282 may include one or more components that facilitate the generation of data for the substrate. For example, the substrate measurement subsystem can include a spectra sensing component for sensing spectra or spectrum from a portion of the substrate and generating spectral data for the substrate. In some embodiments, the spectra sensing component can be an interchangeable component that can be configurable based on a type of process performed at the manufacturing system or a target type of measurements to be obtained at the substrate measurement subsystem. For example, one or more components of the spectra sensing component can be interchanged at the substrate measurement subsystem to enable the collection of reflectometry spectral data, ellipsometry spectral data, hyperspectral imaging data, chemical imaging (e.g., x-ray photoelectron spectroscopy (XPS), energy-dispersive x-ray spectroscopy (EDX), (x-ray fluorescence (XRF), etc.) data, and so forth.

Substrate measurement subsystem 282 may include a controller 283 configured to execute one or more instructions for generating data associated with a portion of substrate 202. Substrate measurement subsystem 282 may include a substrate sensing component 284 configured to detect when substrate 202 is transferred to substrate measurement subsystem 282. Substrate sensing component 284 may include any component configured to detect when substrate 202 is transferred to substrate measurement subsystem 282. For example, substrate sensing component 284 may include an optical sensing component that transmits an optical beam across an entrance to substrate measurement subsystem 282. Substrate sensing component 284 may detect that a substrate 202 has been transferred to substrate measurement subsystem 282 responsive to substrate 202 breaking the optical beam transmitted across the entrance to substrate measurement subsystem 282 as substrate 202 is placed within substrate measurement subsystem 282. Responsive to detecting that substrate 202 has been transferred to substrate measurement subsystem 282, substrate sensing component 284 may transmit an indication to controller 283 indicating that substrate 202 has been transferred to substrate measurement subsystem 282.

In some embodiments, substrate sensing component 284 may be further configured to detect identifying information associated with substrate 202. In some embodiments, substrate 202 may be embedded within a substrate carrier (not shown) when transferred to substrate measurement subsystem 282. The substrate carrier may include one or more registration features that enable identification of substrate 202. For example, an optical sensing component of substrate sensing component 284 may detect that substrate 202, embedded within the substrate carrier, has broken the optical beam transmitted across the entrance to substrate measurement subsystem 282. The optical sensing component may further detect one or more registration features included on the substrate carrier. Responsive to detecting the one or more registration features, the optical sensing component may generate an optical signature associated with the one or more registration features. Substrate sensing component 284 may transmit the optical signature generated by the optical sensing component to controller 283 along with the indication that the substrate has been placed within substrate measurement subsystem 282. Responsive to receiving the optical signature from sensing component 284, controller 283 may analyze the optical signature to determine the identifying information associated with substrate 202. The identifying information associated with substrate 202 may include an identifier for substrate 202, an identifier for a process for substrate 202 (e.g., a batch number or a process run number), an identifier of a type for substrate 202 (e.g., a wafer, etc.), and so forth.

Substrate measurement subsystem 282 may include one or more components configured to determine a position and/or an orientation of substrate 202 within substrate measurement subsystem 282. The position and/or orientation of substrate 202 may be determined based on an identification of a reference location of substrate 202. A reference location may be a portion of substrate 202 that includes an identifying feature that is associated with a specific portion of substrate 202. For example, substrate 202 may have a reference tag embedded in a center portion of substrate 202. In another example, substrate 202 may have one or more structural features included on the surface of the substrate 202 at a center portion of substrate 202. Controller 283 may determine an identifying feature associated with a specific portion of substrate 202 based on determined identifying information for substrate 202. For example, responsive to determining that substrate 202 is a wafer, controller 283 may determine one or more identifying features that are generally included at a portion of a wafer.

Controller 283 may identify the reference location for substrate 202 using one or more camera components 285 configured to capture image data for substrate 202. Camera components 285 may generate image data for with one or more portions of the substrate 202 and transmit the image data to controller 283. Controller 283 may analyze the image data to identify an identifying feature associated with a reference location for substrate 202. Controller 283 may further determine a position and/or orientation of substrate 202 as depicted in the image data based on the identified identifying feature of substrate 202. Controller 283 may determine a position and/or orientation of substrate 202 based on the identified identifying feature of substrate 202 and the determined position and/or orientation of substrate 202 as depicted in the image data.

Responsive to determining the position and/or orientation of substrate 202, controller 283 may generate positional data associated with one or more portions of substrate 202. In some embodiments, the positional data may include one or more coordinates (e.g., Cartesian coordinates, polar coordinates etc.) each associated with a portion of substrate 202, where each coordinate is determined based on a distance from the reference location for substrate 202. For example, responsive to determining the position and/or orientation of substrate 202, controller 283 may generate first positional data associated with a portion of substrate 202 that includes the reference location, where the first positional data includes a Cartesian coordinate of (0,0). Controller 283 may generate second positional data associated with a second portion of substrate 202 that is relative to the reference location. For example, a portion of substrate 202 that is located approximately 2 nanometers (nm) due east of the reference location may be assigned a Cartesian coordinate of (0, 1). In another example, a portion of substrate 202 that is located 5 nms due north of the reference location may be assigned a Cartesian coordinate of (1,0).

Controller 283 may determine one or more portions of substrate 202 to measure based on positional data determined for substrate 202. In some embodiments, controller 283 may receive one or more operations of a process recipe associated with substrate 202. In such embodiments, controller 283 may further determine the one or more portions of substrate 202 to measure based on one or more operations of the process recipe. For example, controller 283 may receive an indication that an etch process was performed for substrate 202 where several structural features were etched onto the surface of substrate 202. As a result, controller 283 may determine one or more structural features to measure and the expected locations of the features at various portions of substrate 202.

Substrate measurement subsystem 282 may include one or more measurement components for measuring substrate 202. In some embodiments, substrate measurement subsystem 282 may include one or more spectra sensing components 287 configured to generate spectral data for one or more portions of substrate 202. As discussed previously, spectral data may correspond to an intensity (i.e., a strength or amount of energy) of a detected wave of energy for each wavelength of the detected wave.

In one embodiment, multiple wave lengths may be included in reflected energy waves received by substrate measurement subsystem 282. Each reflected energy wave may be associated with a different portion of substrate 202. In some embodiments, an intensity may be measured for each reflected energy wave received by substrate measurement subsystem 282. Each intensity can be measured for each wavelength of reflected energy waves received by substrate measurement subsystem 282. The association between each intensity and each wavelength can be the basis for the formation of spectral data. In some embodiments, one or more wavelengths can be associated with an intensity value that is outside of an expected range of intensity values. In such embodiments, the intensity value that is outside of the expected range of intensity values can be an indication that a defect exists at a portion of substrate 202.

The measurement components for measuring substrate 202 can also include non-spectral sensing components configured to collect and generate non-spectral data. For example, the measurement components can include an eddy current sensor or a capacitive sensor. Although some embodiments of the present description may refer to collecting and using spectral data for substrate 202, embodiments of the present description can be applicable to non-spectral data collected for substrate 202.

A spectra sensing component 287 may be configured to detect waves of energy reflected from a portion of substrate 202 and generate spectral data associated with the detected waves. Spectra sensing component 287 may include a wave generator 288 and a reflected wave receiver 291. In some embodiments, wave generator 288 may be a light wave generator configured to generate a beam of light towards a portion of substrate 202. In such embodiments, reflected wave receiver 291 may be configured to receive a reflected light beam from the portion of substrate 202. Wave generator 288 may be configured to generate an energy stream 289 (e.g., a light beam) and transmit energy stream 289 to a portion of substrate 202. A reflected energy wave 290 may be reflected from the portion of substrate 202 and received by reflected wave receiver 291. Although **FIG. 2C** illustrates a single energy wave reflected off the surface of substrate 202, multiple energy waves may be reflected off the surface of substrate 202 and received by reflected wave receiver 291.

Responsive to reflected wave receiver 291 receiving reflected energy wave 290 from the portion of substrate 202, spectra sensing component 287 may measure a wavelength of each wave included in reflected energy wave 289. Spectra sensing component 287 may further measure an intensity of each measured wavelength. Responsive to measuring each wavelength and each wavelength intensity, spectra sensing component 287 may generate spectral data for the portion of substrate 202. Spectra sensing component 287 may transmit the generated spectral data to controller 283. Controller 283 may, responsive to receiving the generated spectral data, generate a mapping between the received spectral data and positional data for the measured portion of substrate 202.

Substrate measurement subsystem 282 may be configured to generate a specific type of spectral data based on a type of measurement to be obtained at substrate measurement subsystem 282. In some embodiments, spectra sensing component 287 may be a first spectra sensing component that is configured to generate one type of spectral data. For example, spectra sensing component 287 may be configured to generate reflectometry spectral data, ellipsometry spectral data, hyperspectral imaging data, chemical imaging data, thermal spectral data, or conductive spectral data. In such embodiments, the first spectra sensing component may be removed from substrate measurement subsystem 282 and replaced with a second spectra sensing component configured to generate a different type of spectral data (e.g., reflectometry spectral data, ellipsometry spectral data, hyperspectral imaging data, or chemical imaging data).

Controller 283 may determine a type of data (i.e., spectral data, non-spectral data) to be generated for substrate 202 based on a type of measurement to be obtained for one or more portions of substrate 202. In some embodiments, controller 283 may determine the one or more types of measurements based on a notification received from system controller 228 of **FIG. 2A****.** In other or similar embodiments, controller 283 may determine the one or more types of measurements based on an instruction to generate a measurement for a portion of substrate 202. Responsive to determining the one or more types of measurements to be obtained, controller 283 may determine the type of data to be generated for substrate 202. For Example, controller 283 can determine that spectral data is to be generated for substrate 202 and that the second spectra sensing component is an optimal sensing component for obtaining the determined type of measurements for the one or more portions of substrate 202. Responsive to determining the second sensing component is the optimal sensing component, controller 283 may transmit a notification to the system controller indicating that the first spectra sensing component should be replaced with the second spectra sensing component and the second spectra sensing component should be used to obtain the one or more types of measurements for the one or more portions of substrate 202. System controller 128 may transmit the notification to a client device connected to the manufacturing system where the client device may provide the notification to a user of the manufacturing system (e.g., an operator) via a GUI.

In other or similar embodiments, spectra sensing component 287 may be configured to generate multiple types of spectral data. In such embodiments, controller 283 may cause spectra sensing component 287 to generate a specific type of spectral data based on the type of measurements to be obtained for one or more portions of substrate 202, in accordance with previously described embodiments. Responsive to determining the type of measurements to be obtained, controller 283 may determine that a first type of spectral data is to be generated by spectra sensing component 287. Based on the determination that the first type of spectral data is to be generated by spectra sensing component 287, controller 283 may cause spectra sensing component 287 to generate the first type of spectral data for the one or more portions of substrate 202.

As described previously, controller 283 may determine one or more portions of substrate 202 to measure at substrate measurement subsystem 282. In some embodiments, one or more measurement components, such as spectra sensing component 287, may be stationary components within substrate measurement subsystem 282. In such embodiments, substrate measurement subsystem 282 may include one or more positional components 295 configured to modify a position and/or an orientation of substrate 202 with respect to spectra sensing component 287. In some embodiments, positional components 295 may be configured to translate substrate 202 along a first axis and or a second axis, relative to spectra sensing component 287. In other or similar embodiments, positional components 295 may be configured to rotate substrate 202 around a third axis relative to spectra sensing component 287.

As spectra sensing component 287 generates spectral data for one or more portions of substrate 202, positional components 295 may modify the position and/or orientation of substrate 202 in accordance with the one or more determined portions to be measured for substrate 202. For example, prior to spectra sensing component 287 generating spectral data for substrate 202, positional components 295 may position substrate 202 at Cartesian coordinate (0,0) and spectra sensing component 287 may generate first spectral data for substrate 202 at Cartesian coordinate (0,0). Responsive to spectra sensing component 287 generating first spectral data for substrate 202 at Cartesian coordinate (0,0), positioning components 240 may translate substrate 202 along a first axis so that spectra sensing component 287 is configured to generate second spectral data for substrate 202 at Cartesian coordinate (0,1). Responsive to spectra sensing component 287 generating second spectral data for substrate 202 at Cartesian coordinate (0,1), controller 283 may rotate substrate 202 along a second axis so that spectra sensing component 287 is configured to generate third spectral data for substrate 202 at Cartesian coordinate (1,1). This process may occur multiple times until spectral data is generated for each determined portion of substrate 202.

In some embodiments, one or more layers 297 of material may be included on a surface of substrate 202. The one or more layers 297 may include etch material, photoresist material, mask material, deposited material, etc. In some embodiments, the one or more layers 297 may include an etch material to be etched according to an etch processed performed at a processing chamber. In such embodiments, spectral data may be collected for one or more portions of the un-etched etch material of the layer 297 deposited on substrate 202, in accordance with previously disclosed embodiments. In other or similar embodiments, the one or more layers 297 may include an etch material that has already been etched according an etch process at the processing chamber. In such embodiments, one or more structural features (e.g., lines, columns, openings, etc.) may be etched into the one or more layers 297 of substrate 202. In such embodiments, spectral data may be collected for one or more structural features etched into the one or more layers 297 of substrate 202.

In some embodiments, substrate measurement subsystem 282 may include one or more additional sensors configured to capture additional data for substrate 202. For example, substrate measurement subsystem 282 may include additional sensors configured to determine a thickness of substrate 202, a thickness of a film deposited on the surface of substrate 202, etc. Each sensor may be configured to transmit captured data to controller 283.

Responsive to receiving at least one of the spectral data, the positional data, or the property data for the substrate 202, controller 283 may transmit the received data to system controller 228 for processing and analysis, in accordance with embodiment described herein.

In some embodiments, substrate measurement subsystem 282 includes one or more image capture devices 299 connected to controller 283, such as a camera (e.g., including a complementary metal oxide semiconductor (CMOS) sensor or a charge coupled device (CCD) sensor). The image capture device(s) 299 may generate images (e.g., two-dimensional (2D) color images, infrared (IR) images, near-infrared images, etc.). The images may be processed together with spectral data generated by spectra sensing component 287 by one or more trained machine learning model to make determinations about one or more chamber components in embodiments.

**FIG. 3** depicts an illustrative system architecture 300 for substrate placement prediction for a processing chamber, according to aspects of the present disclosure. In some embodiments, system architecture 300 can include or be a part of one or more components of computer architecture 100 and/or manufacturing system 200. System architecture 300 can include one or more components of manufacturing equipment 122 (e.g., substrate measurement system 126), server machine 320, and server machine 350.

As described previously, manufacturing equipment 122 can produce products following a recipe or performing runs over a period of time. Manufacturing equipment 122 can include a process chamber 310 configured to perform a substrate process for a substrate according to a substrate process recipe. In some embodiments, the recipe may be a blanket wafer recipe that deposits a film over a test substrate. In some embodiments, the recipe may be a blanket wafer recipe that etches the surface of a test substrate. In some embodiments, process chamber 310 can be any of process chamber 214, 218, 218, described with respect to **FIG. 2A****.** Manufacturing equipment 122 can also include substrate measurement system 126, as described herein.

Manufacturing equipment 122 can be coupled to server machine 320. Server machine 320 can include processing device 322 and/or data store 332. In some embodiments, processing device 322 can be configured to execute one or more instructions to perform operations at manufacturing equipment 122. For example, processing device 322 can include or be a part of system controller 228, described with respect to **FIG. 2A****.** Data store 332 can include or be part of data store 150 and/or data store 250, in some embodiments.

Processing device 322 can be configured to receive data from one or more components of manufacturing equipment 122 (i.e., via a network). For example, processing device 322 can receive surface profile data (e.g., a wafer map, thickness profile data, etc.) 336 collected by substrate measurement system 126 after a substrate has been processed in a process chamber. In another example, processing device 322 can receive metrology data collected by other metrology equipment before and/or after the substrate process for the substrate. Metrology data can include a metrology measurement value generated for the substrate by integrated metrology equipment. In some embodiments, processing device 322 can store the received spectral data, film thickness profile data, substrate thickness profile data, and/or the received metrology data at data store 332.

Processing device 352 can include a substrate placement engine 330. Substrate placement engine 330 at processing device 322 can be configured to determine a recommended placement (e.g., a recommended location) for substrates processed in a process chamber 310. The process chamber 310 may be a processing chamber that processed a measured substrate. Substrate placement engine 330 can determine one or more substrate placement metrics for one or more substrates processed in a process chamber 310 that processed a substrate from substrate surface profile data 336. In some embodiments, the substrate placement metric may include a series of values (e.g., vector, matrix, etc.) indicating a correlation of a particular data combination, correlation, pattern, and/or relationship present in the sensor data. For example, the substrate placement metric may include a feature vector including binary values indicating the presence or absence of a particular feature in the data.

The substrate placement metrics may be compared against a known pattern and/or combination of substrate placement metrics (e.g., target substrate placement metrics). Target substrate placement metrics may be associated with an ideal substrate placement for optimal processing of the substrate. In response to determining that the substrate placement metrics for one or more substrate placement positions satisfy one or more substrate placement criteria (e.g., conditions relating to processed substrates meeting a threshold specification such as a threshold tilt specification, etc.), substrate placement engine 330 can determine a recommended placement for substrates to be processed and/or may provide an alert to a user. Substrate placement criteria may include a specified combination of values indicated by the substrate placement metrics in some embodiments. Once a recommended substrate placement is determined, substrate placement engine 330 may output instructions for a robot arm to use specific settings (e.g., x settings and/or y settings) to use when placing substrates on a substrate support according to coordinates of the recommended substrate placement.

As illustrated in **FIG. 3****,** processing device 322 can include a training set generator 324 and/or a training engine 326, in some embodiments. In some embodiments, training set generator 324 can correspond to training set generator 172 and/or training engine 326 can correspond to training engine 182, described with respect to **FIG. 1****.** Training set generator 324 can be configured to generate training sets 340 to train machine learning model 334 or a set of machine learning models 334. For example, training set generator 324 can generate a training input based on historical substrate surface profile data 336. The substrate surface profile data 336 (e.g., thickness profile maps) may be associated with etch rates and/or tilt across the surface of one or more substrates processed in a processing chamber. In some embodiments, training set generator 324 can retrieve the historical substrate surface profile data 336 (e.g., substrate thickness profile data) from data store 332 to generate the training input. Training set generator 324 can generate a target output indicating an estimated substrate placement value (e.g., substrate placement metrics) for the training input based on historical substrate surface profile data 336. Training set generator 324 can include the generated training input and the generated target output in a training set 340. The training set 340 may additionally include, for each historical substrate thickness profile, an indicator of substrate placement (e.g., on a substrate support such as an electrostatic chuck relative to an inner diameter of a process kit ring). Further details regarding generating training set 340 are provided with respect to **FIG. 5****.**

Training engine 326 can be configured to train, validate and/or test the machine learning model 334 or sets of machine learning models 334. Training engine 326 can provide training set 340 to train machine learning model(s) 334 and store trained machine learning model(s) 334 at data store 332. In some embodiments, training engine 326 can use a validation set 342 to validate a trained machine learning model 334. Validation set 342 can include surface profile data 336 and associated chamber component condition metrics. Training set generator 324 and/or training engine 326 can generate validation set 342 based on historical surface profile data 336. In some embodiments, validation set 342 can include historical surface profile data 336 that is different from historical surface profile data 336 included in training set 340.

Training engine 326 can provide the historical surface profile data 336 as an input to a trained machine learning model 334 and can extract one or more substrate placement metric(s) for processing a substrate in a processing chamber from one or more outputs of the trained model 334. The input may additionally include ages of one or more components of the processing chamber and/or one or more images of a substrate that was used to generate the historical surface profile data 236. Training engine 326 can assign a performance score to the trained model 334 based on an accuracy of the substrate placement metric(s). Training engine 326 can select the trained model 334 to be used to assess the substrate placement for processing the substrate in a process chamber based on surface profile data for a substrate processed by the process chamber.

As discussed previously, training set generator 324 and/or training engine 326 can be components of processing device 322 at server 320, in some embodiments. In additional or alternative embodiments, training set generator 324 and/or training engine 326 can be components of processing device 352 at server 350. Server 350 can include or be part of a computing system that is separate from manufacturing system 200. As described previously, server 320 can include or be part of system controller 228, described with respect to **FIG. 2A****,** in some embodiments. In such embodiments, server 350 can include or be part of a computing system that is coupled to system controller 228 (i.e., via a network), but is separate from system controller 228. For instance, a user of manufacturing system 200 may be provided with access to data stored at one or more portions of data store 332 or one or more processes executed at processing device 322. However, the user of manufacturing system 200 may not be provided with access to any data stored at one or more portions of data store 354 or any processes executed at processing device 352.

Processing device 352 can be configured to execute training set generator 324 and/or training engine 326 in a similar fashion as processing device 322. In some embodiments, server 350 can be coupled to manufacturing equipment 122 and/or inline metrology equipment 130 via a network. As such, processing device 352 can obtain surface profile data 336 and substrate placement metrics corresponding to surface profile data 336 to be used by training set generator 324 and/or training engine 326 to generate training set 340 and validation set 342, in accordance with embodiments described with respect to processing device 322. In other or similar embodiments, server 350 is not coupled to manufacturing equipment 122 and/or external metrology equipment 130. Accordingly, processing device 352 can surface profile data 336 from processing device 322.

Training set generator 324 at processing device 352 can generate training set 340 in accordance with previously described embodiments. Training engine 326 at processing device 352 can train and/or validate machine learning model 334, in accordance with previously described embodiments. In some embodiments, server 350 can be coupled to other manufacturing equipment and/or other server machines that are different from manufacturing equipment 122 and/or server machine 320. Processing device 352 can obtain surface profile data 336 from the other manufacturing equipment and/or server machines, in accordance with embodiments described herein. In some embodiments, training set 340 and/or validation set 342 can be generated based on surface profile data 336 obtained for substrates processed at process chamber 310 as well as other surface profile data obtained for other substrates processed at process chambers at other manufacturing systems.

In response to training engine 326 selecting trained model 334 to be used, processing device 352 can transmit trained model 334 to processing device 322. Substrate placement engine 330 can use trained model 334 to provide substrate placement recommendations, as previously described.

**FIG. 4** illustrates a model training workflow 405 and a model application workflow 417 for substrate placement determination according to one embodiment. Model training workflow 405 and model application workflow 417 may be performed by processing logic executed by a processor of a computing device. One or more of these workflows 405, 417 may be implemented, for example, by one or more machine learning models implemented on a processing device and/or other software and/or firmware executing on a processing device.

The model training workflow 405 is to train one or more machine learning models (e.g., deep learning models) to determine optimal substrate placement for processing substrates in a process chamber. Model application workflow 417 is to apply the one or more trained machine learning models to perform substrate placement assessment. Each of profile maps 412 may be associated with a thickness profile or other surface profile of a processed substrate. For example, each of profile maps 412 may reflect the thickness of the corresponding substrate subsequent to a processing operation (e.g., an etch operation, etc.) performed on the substrate.

Various machine learning outputs are described herein. Particular numbers and arrangements of machine learning models are described and shown. However, it should be understood that the number and type of machine learning models that are used and the arrangement of such machine learning models can be modified to achieve the same or similar end results. Accordingly, the arrangements of machine learning models that are described and shown are merely examples and should not be construed as limiting.

In some embodiments, one or more machine learning models are trained to perform one or more substrate placement estimation tasks. Each task may be performed by a separate machine learning model. Alternatively, a single machine learning model may perform each of the tasks or a subset of the tasks. For example, a first machine learning model may be trained to determine a substrate placement (e.g., a location on a substrate support for substrate processing), and a second machine learning model may be trained to determine a substrate handoff offset (e.g., a substrate handling robot handoff offset). Additionally, or alternatively, different machine learning models may be trained to perform different combinations of the tasks. In an example, one or a few machine learning models may be trained, where the trained machine learning (ML) model is a single shared neural network that has multiple shared layers and multiple higher level distinct output layers, where each of the output layers outputs a different prediction, classification, identification, etc. For example, a first higher level output layer may determine a substrate placement relative to a first type of chamber component (e.g., electrostatic chuck) and a second higher level output layer may determine a substrate placement relative to a second type of chamber component (e.g., a process kit ring).

One type of machine learning model that may be used to perform some or all of the above tasks is an artificial neural network, such as a deep neural network. Artificial neural networks generally include a feature representation component with a classifier or regression layers that map features to a target output space. A convolutional neural network (CNN), for example, hosts multiple layers of convolutional filters. Pooling is performed, and nonlinearities may be addressed, at lower layers, on top of which a multi-layer perceptron is commonly appended, mapping top layer features extracted by the convolutional layers to decisions (e.g. classification outputs). Deep learning is a class of machine learning algorithms that use a cascade of multiple layers of nonlinear processing units for feature extraction and transformation. Each successive layer uses the output from the previous layer as input. Deep neural networks may learn in a supervised (e.g., classification) and/or unsupervised (e.g., pattern analysis) manner. Deep neural networks include a hierarchy of layers, where the different layers learn different levels of representations that correspond to different levels of abstraction. In deep learning, each level learns to transform its input data into a slightly more abstract and composite representation. Notably, a deep learning process can learn which features to optimally place in which level on its own. The "deep" in "deep learning" refers to the number of layers through which the data is transformed. More precisely, deep learning systems have a substantial credit assignment path (CAP) depth. The CAP is the chain of transformations from input to output. CAPs describe potentially causal connections between input and output. For a feedforward neural network, the depth of the CAPs may be that of the network and may be the number of hidden layers plus one. For recurrent neural networks, in which a signal may propagate through a layer more than once, the CAP depth is potentially unlimited.

Training of a neural network may be achieved in a supervised learning manner, which involves feeding a training dataset consisting of labeled inputs through the network, observing its outputs, defining an error (by measuring the difference between the outputs and the label values), and using techniques such as deep gradient descent and backpropagation to tune the weights of the network across all its layers and nodes such that the error is minimized. In many applications, repeating this process across the many labeled inputs in the training dataset yields a network that can produce correct output when presented with inputs that are different than the ones present in the training dataset.

For model training workflow 405, a training dataset containing hundreds, thousands, tens of thousands, hundreds of thousands or more profile maps 412 of a substrate should be used to form a training dataset. Data may include, for example, a uniformity profile determined using a given number of measurements each associated with a particular target position. This data may be processed to generate one or more training datasets 436 for the training of one or more machine learning models. Training data items in training datasets 436 may include profile maps 412, substrate placements used to process substrates that were measured to generate the profile maps, and/or one or more images of the substrates.

To effectuate training, processing logic inputs the training dataset(s) 436 into one or more untrained machine learning models. Prior to inputting a first input into a machine learning model, the machine learning model may be initialized. Processing logic trains the untrained machine learning model(s) based on the training dataset(s) to generate one or more trained machine learning models that perform various operations as set forth above. Training may be performed by inputting input data such as one or more profile maps 412 (e.g., thickness profile maps, spectra profile maps, roughness profile maps, particle count profile maps, optical constant profile maps, etc.), images and/or age information of components into the machine learning one at a time.

The machine learning model processes the input to generate an output. An artificial neural network includes an input layer that consists of values in a data point. The next layer is called a hidden layer, and nodes at the hidden layer each receive one or more of the input values. Each node contains parameters (e.g., weights) to apply to the input values. Each node therefore essentially inputs the input values into a multivariate function (e.g., a non-linear mathematical transformation) to produce an output value. A next layer may be another hidden layer or an output layer. In either case, the nodes at the next layer receive the output values from the nodes at the previous layer, and each node applies weights to those values and then generates its own output value. This may be performed at each layer. A final layer is the output layer, where there is one node for each class, prediction and/or output that the machine learning model can produce.

Accordingly, the output may include one or more predictions or inferences (e.g., estimations of substrate placement in a process chamber for substrate processing in a process chamber in which a measured substrate was processed). Processing logic may compare the output estimated substrate placement(s) against historical substrate placement(s). Processing logic determines an error (i.e., a classification error) based on the differences between the estimated substrate placement(s) and the target substrate placement(s). Processing logic adjusts weights of one or more nodes in the machine learning model based on the error. An error term or delta may be determined for each node in the artificial neural network. Based on this error, the artificial neural network adjusts one or more of its parameters for one or more of its nodes (the weights for one or more inputs of a node). Parameters may be updated in a back propagation manner, such that nodes at a highest layer are updated first, followed by nodes at a next layer, and so on. An artificial neural network contains multiple layers of "neurons", where each layer receives as input values from neurons at a previous layer. The parameters for each neuron include weights associated with the values that are received from each of the neurons at a previous layer. Accordingly, adjusting the parameters may include adjusting the weights assigned to each of the inputs for one or more neurons at one or more layers in the artificial neural network.

Once the model parameters have been optimized, model validation may be performed to determine whether the model has improved and to determine a current accuracy of the deep learning model. After one or more rounds of training, processing logic may determine whether a stopping criterion has been met. A stopping criterion may be a target level of accuracy, a target number of processed images from the training dataset, a target amount of change to parameters over one or more previous data points, a combination thereof and/or other criteria. In one embodiment, the stopping criteria is met when at least a minimum number of data points have been processed and at least a threshold accuracy is achieved. The threshold accuracy may be, for example, 70%, 40% or 90% accuracy. In one embodiment, the stopping criterion is met if accuracy of the machine learning model has stopped improving. If the stopping criterion has not been met, further training is performed. If the stopping criterion has been met, training may be complete. Once the machine learning model is trained, a reserved portion of the training dataset may be used to test the model. Once one or more trained machine learning models 438 are generated, they may be stored in model storage 445, and may be added to substrate placement engine 330.

For model application workflow 417, according to one embodiment, input data 462 may be input into one or more substrate placement determiners 467, each of which may include a trained neural network or other model. Additionally, or alternatively, one or more substrate placement determiner 467 may apply image processing algorithms to determine chamber component conditions. The input data may include a profile map (e.g., of a polymer layer on a substrate measured using an integrated reflectometry device or substrate measurement system). The input data may additionally optionally include one or more images of the substrate. Based on input data 462, substrate placement determiner(s) 467 may output one or more estimated substrate placement(s) 469. The estimated substrate placement(s) 469 may include a substrate placement relative to a substrate support structure for processing substrates within the process chamber (e.g., optionally as an offset from a center of a substrate support such as an electrostatic chuck). In some examples, a coordinate system based on the substrate support (e.g., based on a center point of the substrate support) may be used to correlate the estimated substrate placement (e.g., position) relative to the substrate support.

An action determiner 472 may determine based on the substrate placement(s) 469 one or more actions 470 to perform. In one embodiment, action determiner 472 compares the substrate placement estimations to one or more substrate placement thresholds. If one or more of the substrate placement estimations meets or exceeds a substrate placement threshold, then action determiner 472 may determine that updating the substrate placement for future substrate placement is recommended, and may output a recommendation or notification to update the substrate placement parameters. In some embodiments, action determiner 472 automatically updates substrate placement metric(s) based on substrate placement(s) 469 meeting one or more criteria. In some examples, substrate placement(s) 469 may include an estimated position that a substrate is to be placed relative to a substrate support (e.g., an electrostatic chuck) and/or relative to a component of a substrate support (e.g., a process kit ring) for processing. The estimated position may be an optimized position for the substrate to minimize tilt in the processed substrate, particularly proximate the edge of the substrate. The substrate placement(s) 469 may include coordinate positions relating a center point of the substrate support to the center point of the substrate. In some examples, the substrate placement(s) 469 may reflect the offset between the center of the substrate and the center of the substrate support. In some embodiments, the offset can be used to determine one or more offsets for a robot handling the substrate (e.g., updated positions for the robot to place and/or "handoff" the substrate, etc.).

**FIG. 5** is a flow chart of a method 500 for generating a training dataset for training a machine learning model to perform substrate placement assessments, according to aspects of the present disclosure. Method 500 is performed by processing logic that can include hardware (circuitry, dedicated logic, etc.), software (such as is run on a general purpose computer system or a dedicated machine), firmware, or some combination thereof. In one implementation, method 500 can be performed by a computer system, such as computer system architecture 100 of FIG. 1. In other or similar implementations, one or more operations of method 500 can be performed by one or more other machines not depicted in the figures. In some aspects, one or more operations of method 500 can be performed by training set generator 324 of server machine 320 or server machine 350, described with respect to FIG. 3.

At block 510, processing logic initializes a training set T to an empty set (e.g., {}). At block 512, processing logic obtains substrate surface data (e.g., reflectometry data of a surface of a film on a substrate, such as a film thickness profile map or wafer map) associated with a substrate processed at a process chamber of a manufacturing system.

At block 514, processing logic obtains substrate placement information for the substrate processed by the process chamber. As described previously, the substrate placement information may include a coordinate position of the substrate relative to the substrate support and/or relative to a component of the substrate support.

At block 516, processing logic generates a training input based on the sensor data obtained for the substrate at block 512. In some embodiments, the training input can include a normalized set of sensor data (e.g., including surface reflectometer data as described herein).

At block 518, processing logic can generate a target output based on the substrate placement information obtained at block 514. The target output can correspond to substrate placement metrics (data indicative of placements for one or more substrate processed in the process chamber) of a substrate processed in the process chamber.

At block 520, processing logic generates an input/output mapping. The input/output mapping refers to the training input that includes or is based on data for the substrate, and the target output for the training input, where the target output identifies a substrate placement, and where the training input is associated with (or mapped to) the target output. At block 522, processing logic adds the input/output mapping to the training set T.

At block 524, processing logic determines whether the training set, T, includes a sufficient amount of training data to train a machine learning model. It should be noted that in some implementations, the sufficiency of training set T can be determined based simply on the number of input/output mappings in the training set, while in some other implementations, the sufficiency of training set T can be determined based on one or more other criteria (e.g., a measure of diversity of the training examples, etc.) in addition to, or instead of, the number of input/output mappings. Responsive to determining the training set, T, includes a sufficient amount of training data to train the machine learning model, processing logic provides the training set, T, to train the machine learning model. Responsive to determining the training set does not include a sufficient amount of training data to train the machine learning model, method 500 returns to block 512.

At block 526, processing logic provides the training set T to train the machine learning model. In some embodiments, the training set T is provided to training engine 326 of server machine 320 and/or server machine 350 to perform the training. In the case of a neural network, for example, input values of a given input/output mapping (e.g., spectral data and/or chamber data for a previous substrate) are input to the neural network, and output values of the input/output mapping are stored in the output nodes of the neural network. The connection weights in the neural network are then adjusted in accordance with a learning algorithm (e.g., backpropagation, etc.), and the procedure is repeated for the other input/output mappings in the training set T. After block 526, machine learning model 190 can be used to provide substrate placements (e.g., substrate placement metrics) for substrates processed in the process chamber.

**FIG. 6** is a flow chart illustrating an embodiment for a method 600 of training a machine learning model to estimate substrate placement for processing a substrate in a process chamber. Method 600 is performed by processing logic that can include hardware (circuitry, dedicated logic, etc.), software (such as is run on a general purpose computer system or a dedicated machine), firmware, or some combination thereof. In one implementation, method 600 can be performed by a computer system, such as computer system architecture 100 of FIG. 1. In other or similar implementations, one or more operations of method 600 can be performed by one or more other machines not depicted in the figures. In some aspects, one or more operations of method 600 can be performed by training engine 326 of server machine 320 or server machine 350, described with respect to FIG. 3.

At block 602 of method 600, processing logic gathers a training dataset, which may include data from a plurality of substrate profile maps (e.g., film thickness profile maps indicating film thickness of a polymer film for a plurality of locations on a substrate, substrate surface profile maps, substrate thickness profile maps, etc.). Each data item of the training dataset may include one or more labels. The data items in the training dataset may include input-level (e.g., image-level) labels that indicate a presence or absence of one or more substrate features associated with the substrate placement. For example, some data items may include a label of tilt present in the processed substrate. In some embodiments, each data item includes a substrate map, which may be an image of a substrate (e.g., a heat map of a substrate). Colors in the heat map may indicate substrate thickness and/or other parameter values (e.g., such as tilt, etc.). Alternatively, actual thickness values may be used for each of many coordinates on the surface of a substrate (e.g., of a substrate).

At block 604, data items from the training dataset are input into the untrained machine learning model. At block 606, the machine learning model is trained based on the training dataset to generate a trained machine learning model that classifies or estimates one or more substrate placements for processing a substrate in a process chamber. The machine learning model may also be trained to output one or more other types of predictions, coordinate-level classifications, decisions, and so on.

In one embodiment, at block 610 an input of a training data item is input into the machine learning model. The input may include data from a substrate profile map (e.g., a substrate surface profile map) indicating one or more surface properties across the substrate (e.g., thickness, optical constant, particle count, roughness, material property, etc.). The data may be input as an image or as a feature vector in embodiments. At block 612, the machine learning model processes the input to generate an output. The output may include one or more substrate placements (e.g., substrate placement values, etc.). The substrate placements may be recommended subset placements for placement of future substrates on a substrate support. The output may additionally or alternatively include one or more substrate handoff offsets for a robot arm. For example, the handoff offset may correlate an initial robot handoff orientation to an updated robot handoff orientation to correspond with a predicted substrate placement for substrate processing.

At block 614, processing logic compares the output probabilities and/or values of substrate placement metrics to known optimal substrate placements associated with the input. At block 616, processing logic determines an error based on differences between the output and the known placements. At block 618, processing logic adjusts weights of one or more nodes in the machine learning model based on the error.

At block 620, processing logic determines if a stopping criterion is met. If a stopping criterion has not been met, the method returns to block 610, and another training data item is input into the machine learning model. If a stopping criterion is met, the method proceeds to block 625, and training of the machine learning model is complete.

In one embodiment, one or more ML models are trained for application across multiple process chambers, which may be a same type or model of process chamber. A trained ML model may then be further tuned for use for a particular instance of a process chamber. The further tuning may be performed by using additional training data items comprising surface profile maps of substrates processed by the process chamber in question. Such tuning may account for chamber mismatch between chambers and/or specific hardware process kits of some process chambers. Additionally, in some embodiments, further training is performed to tune an ML model for a process chamber after maintenance on the process chamber and/or one more changes to hardware of the process chamber.

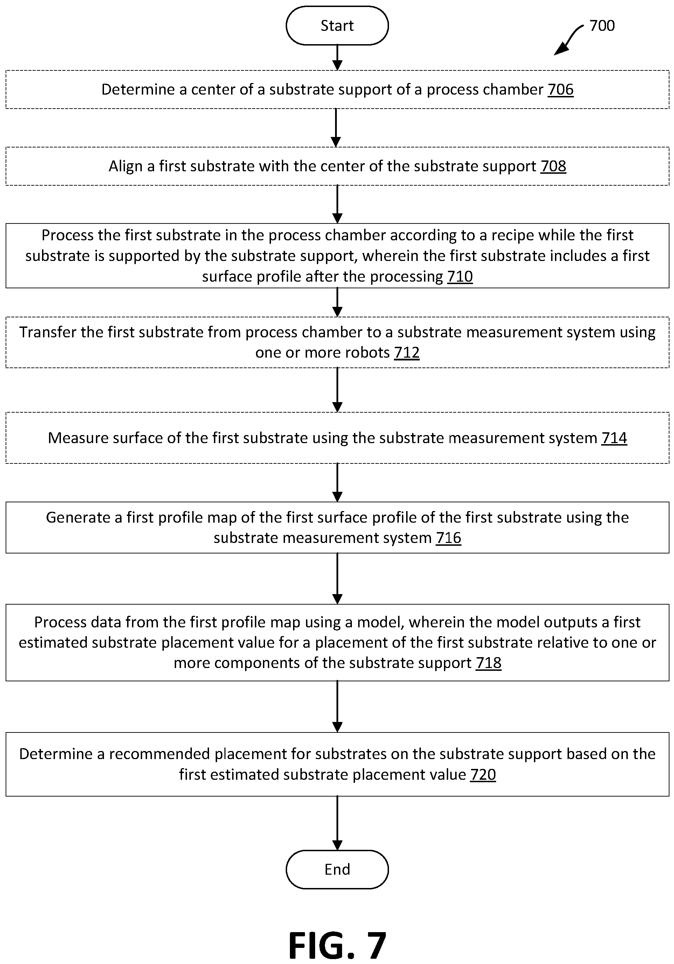

**FIG. 7** is a flow diagram for a method 700 of determining a recommended substrate placement, according to aspects of the present disclosure. Method 700 is performed by processing logic that can include hardware (circuitry, dedicated logic, etc.), software (such as is run on a general purpose computer system or a dedicated machine), firmware, or some combination thereof. In one implementation, method 700 can be performed by a computer system, such as computer system architecture 100 of FIG. 1. In other or similar implementations, one or more operations of method 700 can be performed by one or more other machines not depicted in the figures. In some aspects, one or more operations of method 700 can be performed by substrate placement engine 330 of server machine 320, described with respect to FIG. 3.

At block 706, processing logic (e.g., of a processing device) determines the center of a substrate support (e.g., an electrostatic chuck) of a process chamber of a substrate processing system (also referred to as a manufacturing system). In some embodiments, the center of the substrate support is determined from data collected by a multi-function wafer. For example, a multi-function wafer (e.g., a camera wafer) may collect images of the electrostatic chuck in the process chamber. The processing device may process the images to determine the center of the electrostatic chuck. The center of the substrate support may correspond to a datum point (e.g., a (0,0) point) of the substrate support.

At block 708, the substrate is aligned with the center of the substrate support. In some embodiments, processing logic causes a robot arm (e.g., of a substrate-handling robot) to place the substrate on the substrate support with the center of the substrate aligned with the center of the substrate support. In some embodiments, the substrate is centered on the substrate support to obtain baseline measurements with respect to placement of the substrate. In some embodiments, the substrate is a proxy substrate (e.g., a test substrate, etc.).

At block 710, the process chamber processes the substrate. For example, the process chamber may perform an etch process to partially remove a film on the surface of the substrate or a film deposition process to deposit a film on the substrate. In some embodiments, the film is a polymer. In other embodiments, the film is a ceramic (e.g., a metal oxide). The processing of the substrate may be performed according to a recipe (e.g., an etch process recipe, a deposition process recipe, etc.). During the processing, the substrate may be supported by a substrate support of the process chamber (e.g., an electrostatic chuck). The substrate may be placed at an initial position in the process chamber prior to the processing (e.g., at block 708) and may remain in the initial position during the processing. After the processing, in some embodiments, the substrate includes a surface profile (e.g., a thickness profile, etc.).

At block 712, one or more robots transfers the substrate from the process chamber to a substrate measurement system. If the substrate measurement system is connected to or included in a transfer chamber, then a transfer chamber robot may remove the substrate from the process chamber and insert the substrate into the substrate measurement system. If the substrate measurement system is connected to or included in a factory interface, then a transfer chamber robot may remove the substrate from the process chamber and place the substrate in a load lock. A factory interface robot may then remove the substrate from the load lock and insert the substrate into the substrate measurement system. The substrate measurement system may be any of the aforementioned substrate measurement systems, such as an integrated reflectometry (IR) device.

At block 714, the substrate measurement system generates measurements of many locations on a surface of the substrate. Each location may have a unique set of coordinates.

At block 716, the substrate measurement system and/or a computing device may generate a profile map of the surface profile of the substrate (e.g., a substrate surface profile map) based on the measurements of the substrate measurement system. The profile map may be or include an image, where each pixel in the image corresponds to a coordinate on the substrate. Each pixel may have an intensity value that corresponds to a measurement value (e.g., thickness value) at the coordinate of the substrate associated with the pixel. In some embodiments, the profile map is indicative of a thickness profile, which is indicative of an etch rate profile. For example, the profile map may reflect a thickness profile of the substrate having undergone an etch process for a predetermined amount of time. In some embodiments, the profile map is indicative of substrate surface defects such as tilt. Tilt is correlated to etch rate, in some embodiments. In some embodiments, the profile may be or include a feature vector, where each entry in the feature vector is associated with a coordinate of the substrate, and where each entry may have a value that represents a value of the surface profile at the coordinate of the substrate. In some embodiments, the processing logic (e.g., of the measurement system and/or of the computing device) may determine an etch rate profile map corresponding to an etch rate proximate the edge of the substrate.

At block 718, a computing device processes data from the profile map (e.g., thickness profile map, particle map, optical constant map, roughness map, etch rate profile map, etc.) using a model. In some embodiments, the computing device uses one or more trained machine learning models to process data from the profile map. In some embodiments, the trained machine learning model was trained using data collected from multiple substrates processed according to the recipe. For example, a set of substrates are processed according to the recipe at various placements (e.g., positions) on the substrate support. Profile maps of the processed substrates may be generated. The profile maps and corresponding substrate placements may be input as training data to train the machine learning model.

In some embodiments, the model is a physics-based model or a statistical model. In some embodiments, the model outputs an estimated substrate placement value (e.g., an estimated substrate placement metric) for placement of the substrate relative to one or more components of the substrate support. In some examples, the model outputs a placement metric of the substrate (e.g., a coordinate position of the substrate on the substrate support) that corresponds to a placement relative to the substrate support (e.g., the electrostatic chuck) and/or one or more components of the substrate support (e.g., the process kit ring). In some embodiments, the output of the model is based on the etch rate profile map determined at block 716. In some embodiments, the output of the model indicates that the substrate was not placed in an optimal position for the processing. In one embodiment, rather than or in addition to using a trained ML model, one or more computer vision algorithms are used to process the profile map(s).

At block 720, processing logic (e.g., of the computing device) determines a recommended placement for substrates on the substrate support based on the estimated placement value (e.g., output by the model at block 718). In some examples, the computing device may determine a location on the substrate support for placement of the substrate using the estimated substrate placement value. Specifically, the computing device may determine a coordinate position based on a value (or values) output from the model at block 718. In some embodiments, the computing device may determine a gap that is to exist between the edge of the substrate and the inner diameter of the process kit ring. In some embodiments, the gap is not uniform around the substrate. For example, the gap may be larger on one side of the substrate than on the opposite side of the substrate. Thus, the gap may be correlated to the placement of the substrate (e.g., on the electrostatic chuck, within the inner diameter of the process kit ring, etc.). The processing logic may then cause another substrate to be placed in the process chamber (e.g., via a substrate-handling robot) according to the recommended placement as described herein below.

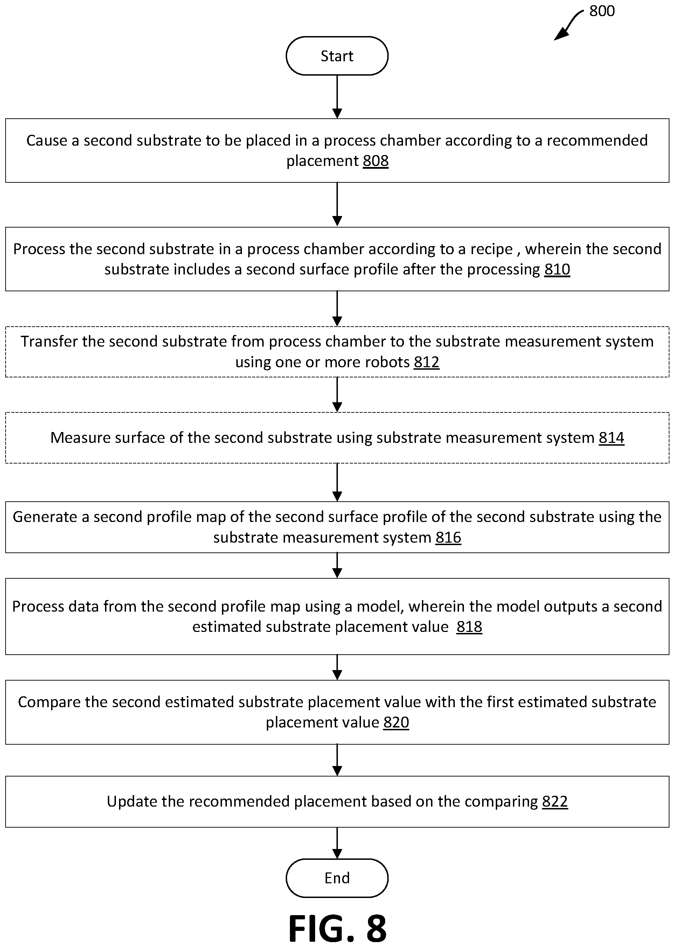

**FIG. 8** is a flow diagram for a method 800 of comparing a second estimated substrate placement with a first estimated substrate placement, according to aspects of the present disclosure. In some embodiments, method 800 is performed in conjunction with method 700 described herein above. For example, method 700 may correspond to processing a first substrate while method 800 may correspond to processing a second substrate and comparing the results of the second substrate with the results of the first substrate. Method 800 is performed by processing logic that can include hardware (circuitry, dedicated logic, etc.), software (such as is run on a general purpose computer system or a dedicated machine), firmware, or some combination thereof. In one implementation, method 800 can be performed by a computer system, such as computer system architecture 100 of FIG. 1. In other or similar implementations, one or more operations of method 800 can be performed by one or more other machines not depicted in the figures. In some aspects, one or more operations of method 800 can be performed by substrate placement engine 330 of server machine 320, described with respect to FIG. 3.

At block 808, a substrate (e.g., a second substrate) is placed in a process chamber according to a recommended placement (e.g., determined at block 720 of method 700). In some embodiments, processing logic causes a robot to place the substrate on a substrate support (e.g., an electrostatic chuck) within the process chamber. The robot may place the substrate at a position such that the center of the substrate is offset from the center of the substrate support, according to the recommended placement. For example, the recommended placement may specify that the center of the substrate is to be offset from the center of the electrostatic chuck a specified amount in a specified direction. The amount and direction of the offset may be the difference between a first robot handoff orientation and a second robot handoff orientation. In some examples, the first robot handoff orientation is a baseline (e.g., default, etc.) orientation, while the second robot handoff orientation is an updated orientation based on the offset. The robot may place the substrate on the electrostatic chuck the specified amount of the offset from the center of the electrostatic chuck in the direction of the offset.

At block 810, the substrate is processed in the process chamber according to a recipe (e.g., the recipe of block 710 of method 700). The recipe may be an etch process recipe and/or a deposition process recipe. Similar to the substrate processed at block 710 of method 700, the substrate includes a surface profile after the processing. The surface profile may be a thickness profile.

At block 812, the substrate is transferred (e.g., by one or more transfer robots) from the process chamber to a substrate measurement system (e.g., similar to at block 712 of method 700).

At block 814, the substrate measurement system measures the surface of the substrate (e.g., similar to at block 714 of method 700).

At block 816, the substrate measurement system and/or a computing device may generate a profile map of the surface profile of the substrate (e.g., similar to at block 716 of method 700) based on the measurements of the substrate measurement system. In some embodiments, the profile may be an image or may include an image. The profile map may be indicative of an etch rate profile.

At block 818, a computing device processes data from the profile map (e.g., thickness profile map, particle map, optical constant map, roughness map, etc.) using a model (e.g., a trained machine learning model, a physics-based model, a statistical model, etc.). In some embodiments, the model outputs an estimated substrate placement value (e.g., an estimated substrate placement metric, etc.).

At block 820, processing logic (e.g., of the computing device) compares the estimated substrate placement value output from the model at block 818 with another estimated substrate placement value (e.g., the estimated substrate placement value of block 718 of method 700). The processing logic may determine whether the recommended placement is to be updated based on the comparison. For example, responsive to the estimated substrate placement values being the same (e.g., substantially the same, within a threshold difference of each other, etc.), the processing logic may determine that the recommended placement is adequate. Responsive to the estimated substrate placement values being different (e.g., outside a threshold difference of each other, etc.), the processing logic may determine that the recommended placement should be updated.

At block 822, processing logic updates the recommended placement based on the comparing at block 820.

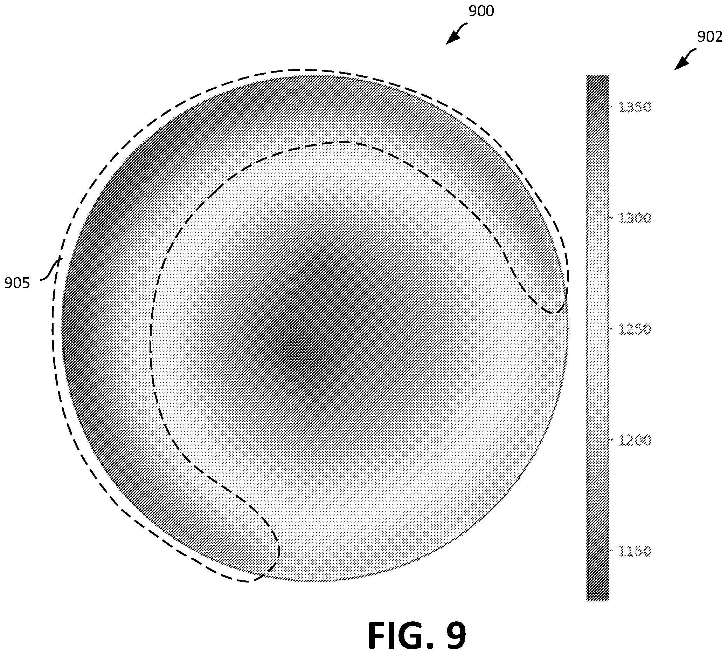

**FIG. 9** is a profile map 900 of a processed substrate, according to aspects of the present disclosure. The profile map 900 is a heat map that shows temperatures of different locations on the substrate during processing in a process chamber. The temperatures may be based on thicknesses at the different locations of a film deposited or etched during the processing. A key 902 is provided to show how to interpret the profile map 900. As shown, hot spot 905 is not uniform around the edge of the substrate. In some embodiments, the methods described herein may provide a substrate having no hot spots (e.g., substantially no hot spots, substantially uniform temperatures, etc.). Non-uniform hot spots may be indicative of increased etch rate which is correlated to increased substrate tilt. The substrate may have been too close to the process kit ring (e.g., of the substrate support in the process chamber) on the sides proximate the hot spot 905 during the processing. For example, the gap between the edge of the substrate and the inner diameter of the process kit ring may have been too small or too big proximate the hot spot 905. The non-uniform hot spot 905 around the edge of the substrate may indicate that excessive tilt is present in the features of the processed substrate proximate the edge of the substrate. Thus, placement of the substrate for processing should be changed, according to some embodiments described herein.

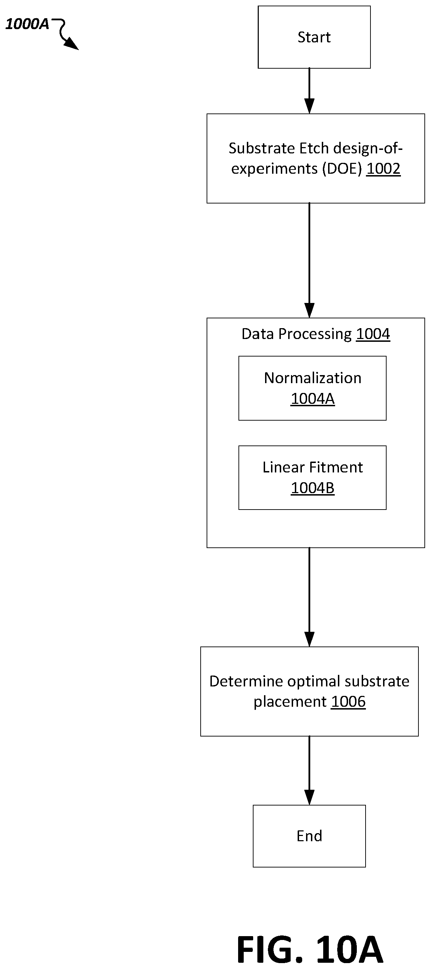

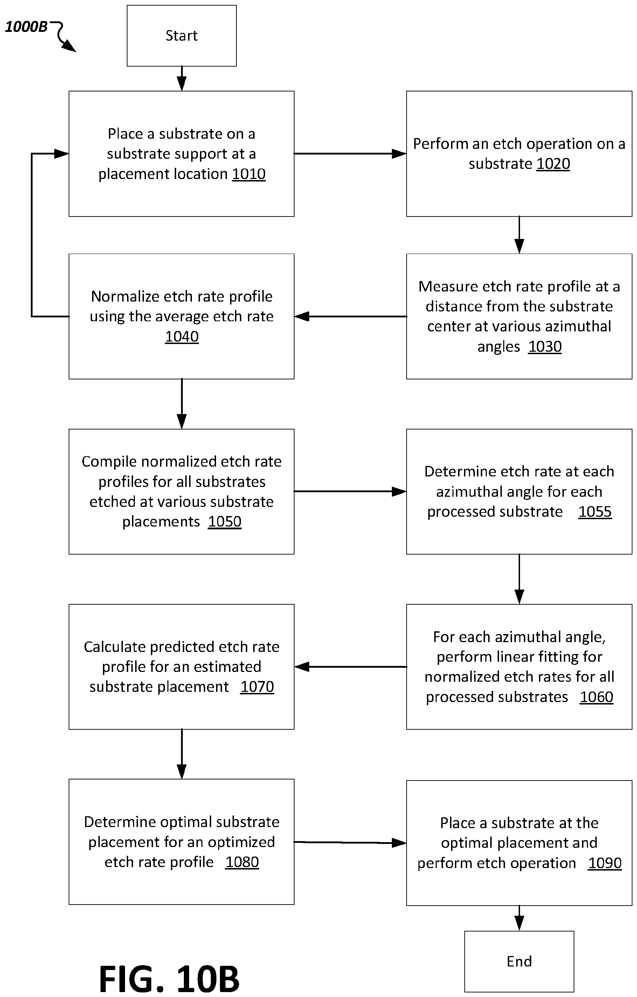

**FIGS. 10A-10B** are flow diagrams for methods of determining optimal substrate placement, according to aspects of the present disclosure. **FIG. 10A** illustrates a method 1000A for determining optimal substrate placement, according to some embodiments. **FIG. 10B** illustrates a method 1000B for determining optimal substrate placement, according to some embodiments. In some embodiments, method 1000A and/or 1000B may be methods for performing an all angle fitting (AAF) algorithm that recommends a wafer placement adjustment. In some embodiments, method 1000A and/or 1000B are for optimizing etch profile uniformity, especially near the extreme edge of a substrate.

Referring to FIG. 10A, a design-of-experiments (DOE) is performed at block 1002. In some embodiments, multiple substrates (e.g., test substrates) are processed (e.g., etched) at various positions on a substrate support in a process chamber. In some embodiments, a first substrate is placed at a first placement location (e.g., a first position) on a substrate support. The first substrate may be processed and the processed first substrate may have a first surface profile. In some embodiments, the first surface profile is measured using a substrate measurement system described herein above. In some embodiments, a second substrate is placed at a second placement location on the substrate support different from the first placement location. The second substrate is then processed and the surface profile of the processed second substrate is measured. A third substrate may be processed at a third placement location and the surface profile of the processed third substrate may be subsequently measured.

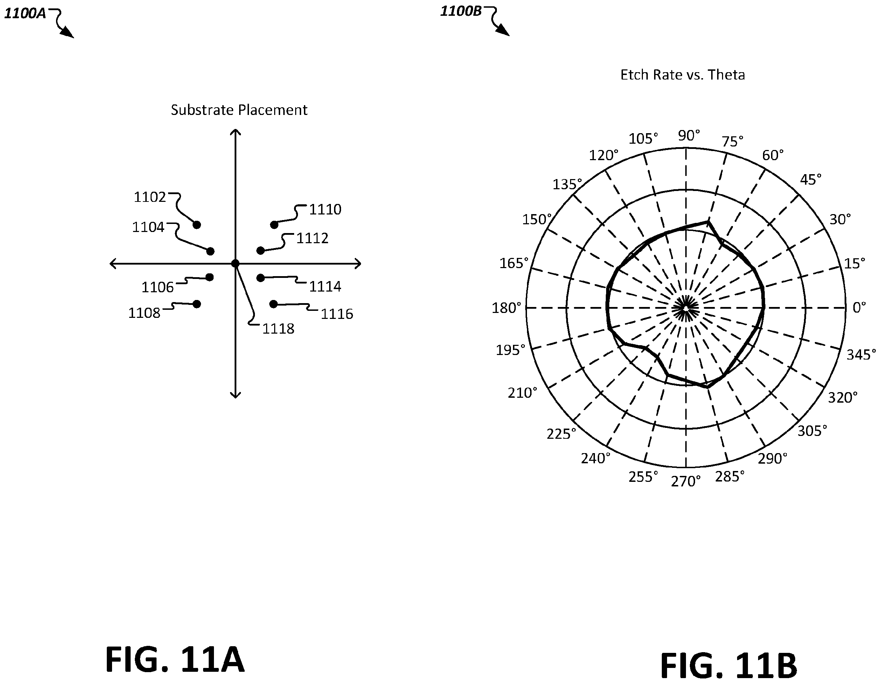

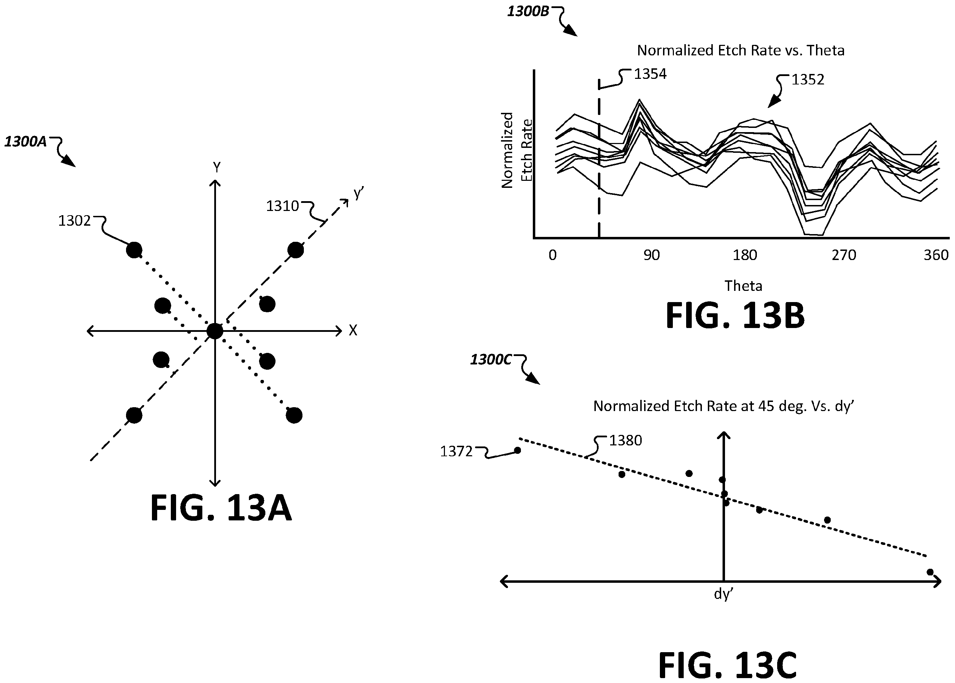

Referring to **FIG. 11A****,** an example plot diagram 1100A of a substrate placement DOE is shown. Referring to **FIG. 13A****,** an example plot diagram 1300A illustrating substrate placement in a DOE is shown. In some embodiments, plot diagram 1100A may correspond with plot diagram 1300A. In some embodiments, substrates may be placed at various locations on the substrate support for performing the DOE. Referring again to FIG. 11A, in some embodiments, a substrate is placed and processed at each of the placement locations 1102-1118. In some embodiments, location 1118 may correspond to a center of a substrate support. In some embodiments, a first substrate may be placed at a first location 1102 and processed, a second substrate may be placed at a second location 1104 and processed, a third substrate may be placed at a third location 1106 and processed, and so on. Although FIG. 11A shows nine possible placement locations for processing substrates, a DOE can be performed with fewer than nine processed substrates at different placement locations. In some embodiments, no more than two placement locations can lie on the same line in two-dimensional space. In some embodiments, at least one placement location of a DOE lies off a linear line formed between two other placement locations. In some embodiments, a DOE can be performed with more than nine processed substrates at different placement locations. Including a higher number of processed substrates at various placement locations may increase the accuracy of the DOE. An increased accuracy may be obtained if the DOE placement locations cover more azimuthal angles. For example, the placement locations shown in FIG. 13A form an "X"-shape pattern. Adding additional placement locations to the DOE that form another "X"-shape pattern of a different angle between the legs of the "X" (e.g., a shallower angle or a deeper angle) may make the prediction more accurate. In some embodiments, a DOE can be performed with as few as three processed substrates at three different placement locations .

Referring again to FIG. 10A, data processing is performed at block 1004. In some embodiments, etch rates at locations near the edge of each of the substrates processed in the DOE (e.g., at block 1002) are determined. For example, etch rate can be determined by subtracting the processed thickness of a substrate from the unprocessed thickness, and dividing by the processing time. In some embodiments, etch rates are determined for locations at a radial position proximate the edge of the processed first substrate for several azimuthal angles. Referring to **FIG. 11B****,** a radial plot of substrate etch rates with respect to azimuthal angle theta are shown. In some embodiments, etch rates are determined for all azimuthal angles about the center of a processed substrate. In some embodiments, etch rates are determined for several azimuthal angles about the center of a processed substrate such that the determined etch rates are representative of the entire etch rate profile. The determined etch rates may be only representative of all the azimuthal angles. For example, etch rates can be determined at azimuthal angles of 0°, 15°, 30°, 45°, etc. around the processed substrate proximate the edge of the substrate. However, etch rates can be determined at various azimuthal angles of different graduations than illustrated in FIG. 11B. For example, etch rates can be determined at 0°, 10°, 20°, 30°, etc. or 0°, 30°, 60°, 95°, etc. FIG. 11B shows the etch rates of a processed substrate at various azimuthal angles about the center of the substrate near the edge of the substrate.

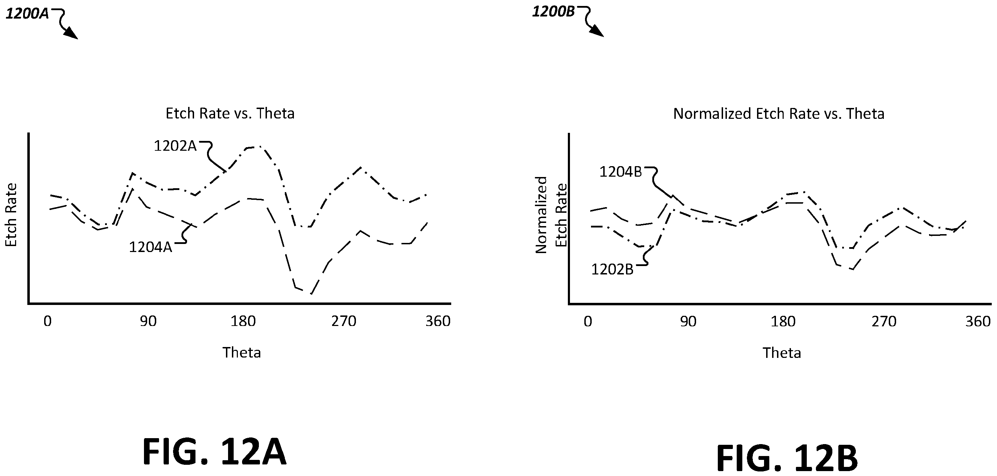

Referring again to FIG. 10A, at block 1004A, the etch rates may be normalized. Normalizing the etch rate my help to account for variance in etching chamber conditions. Normalizing the etch rates may help to account for variances in substrates such as slight variances in composition or defects. The substrate variances may lead to inconsistencies in substrate processing and therefore may lead to inconsistent data. Normalization of the etch rates may aid in removing the effects outlying defects in substrates or defects and/or variances in processing from the dataset. In some embodiments, the etch rates are normalized using the average etch rate. In some examples, for a first etch rate profile (e.g., an etch rate profile shown in FIG. 11B or FIG. 12A), a first average etch rate is determined. Each value of the first etch rate profile is divided by the first average etch rate to determine a first normalized etch rate profile. In some similar examples, for a second etch rate profile, a second average etch rate is determined. Each value of the second etch rate profile is divided by the second average etch rate to determine a second normalized etch rate profile. Other methods of normalizing the etch rate data may be used. More details regarding data normalization are discussed herein below with respect to FIG. 10B.

Referring to **FIG. 12A****,** an example plot of substrate etch rates with respect to azimuthal angle theta are shown. An etch rate profile 1202A corresponding to etch rates of a first substrate proximate the edge of the first substrate is shown. An etch rate profile 1204A corresponding to etch rates of a second substrate proximate the edge of the second substrate is shown. Referring to **FIG. 12B****,** an example plot of normalized substrate etch rates with respect to azimuthal angle theta are shown. Normalized etch rate profile 1202B may correspond to etch rate profile 1202A of FIG. 12A and normalized etch rate profile 1204B may correspond to etch rate profile 1204A of FIG. 12A. By normalizing the etch rate profiles, comparison of etch rate values of discrete azimuthal angles (e.g., discrete values of theta) can be made by eliminating at least some of the inconsistencies between processed substrates from the data.

At block 1004B, a linear fitment is made using corresponding values of the normalized etch rates of the substrates processed as part of the DOE (e.g., normalized etch rate values of the processed substrates at the same azimuthal angle). Referring to **FIG. 13B****,** an example graphical representation 1300B of normalized substrate etch rates of substrates processed at various placement locations is shown. For a particular azimuthal angle 1354 (45° shown in FIG. 13B), normalized etch rates are retrieved from the normalized etch rate profiles 1352 of each of the processed substrates. Referring to **FIG. 13C****,** a plot 1300C of a linear fit for normalized substrate etch rates is shown. Normalized etch rates 1372 for each processed substrate at azimuthal angle 1354 are plotted with respect to a differential position along a vector 1310 of FIG. 13A. More details regarding vector 1310 of FIG. 13A are described herein below. A linear fit 1380 is formed through the plotted normalized etch rates 1372. The linear fit 1380 may represent a predicted etch rate of a processed substrate at various positions along the vector 1310 at the corresponding azimuthal angle. A linear fit may be determined for the normalized etch rates at each azimuthal angle.

Referring again to FIG. 10A, at block 1006, using the linear fitment data determined at block 1004B, an optimal substrate placement location is determined. In some embodiments, an etch rate profile can be predicted for any substrate placement using the linear fit data. By predicting an etch rate profile at various placement locations, an optimal location can be determined that satisfies one or more metrics. For example, a placement location can be determined that minimizes an etch rate range (e.g., etch rate range proximate the edge of a substrate) or an etch rate standard deviation (e.g., etch rate standard deviation proximate the edge of a substrate). Minimizing the etch rate range and/or etch rate standard deviation can result in more consistently-processed substrates, particularly near the edge of the substrate. Once an optimal substrate placement location is determined, the optimal placement is recommended to the substrate processing system. A substrate can be caused to be placed on a substrate support in a process chamber according to the recommended placement.

Referring to **FIG. 10B****,** a method 1000B for determining an optimal substrate placement for processing in a process chamber is shown. Method 1000B is described with reference to an etch process, but may equally be performed for a deposition process. Accordingly, any description with reference to etch, etch rate, etch rate profile, etc. may also apply to deposition, deposition rate, deposition rate profile, and so on. Method 1000B may also be applicable to any other metrics which show linear or high order response to substrate placement at a specific azimuthal angle. For example, etch rate gradient (e.g., etch rate difference from a radius of 146mm and a radius of 148mm) for blanket substrate and etch tilt profile for patterned substrate could also demonstrate similar response to substrate placement. At block 1010, a substrate is placed at a placement location on a substrate support. The substrate may be a test substrate that is to be processed as part of a DOE. The substrate may be placed at one of the locations 1102-1118 shown in FIG. 11A. At block 1020, an etch operation may be performed on the substrate to remove material from the substrate (or a deposition operation may be performed to add material to the substrate). At block 1030, using a substrate measurement system, etch rate or deposition rate may be measured proximate the edge of the substrate at a radial distance from the center of the substrate at multiple azimuthal angles. In some examples, etch rate or deposition rate is measured at a distance between approximately 140 mm and 150 mm from the center of the substrate about the center axis of the substrate. An etch rate profile or deposition rate profile (e.g., shown in FIG. 11B for a single substrate and shown in FIG. 12A for two substrates) can be constructed using the measured etch rates or deposition rates at the various azimuthal angles. At block 1040, the etch rate profile or deposition rate profile is normalized. In some embodiments, the etch rate profile or deposition rate profile is normalized using an average etch rate for the etch rate profile or an average deposition rate for the deposition rate profile. For example, referring to FIG. 12A, for etch rate profile 1202A, an average etch rate may be determined from azimuthal angle 0° to azimuthal angle 360°. Each value of etch rate over the etch rate profile may be divided by the average etch rate to calculate a normalized etch rate profile 1202B of FIG. 12B.

Referring again to FIG. 10B, blocks 1010-1040 can be repeated multiple times for multiple substrates processed as part of the DOE. Each time block 1010 is repeated, the associated substrate is placed at a different placement location on the substrate support. In some embodiments, blocks 1010-1040 are repeated nine times to process nine test substrates at nine different placement locations. In some embodiments, blocks 1010-1040 are repeated as few as three time to process as few as three test substrates at as few as three different placement locations. Including more or fewer substrates in the DOE (and thus repeating blocks 1010-1040 more or fewer times) is dependent on an accuracy threshold of the DOE. For example, if the accuracy threshold is higher, more test substrates are processed. Similarly, if the accuracy threshold is lower, fewer test substrate may be processed.

At block 1050, the normalized etch rate profiles for each of the substrates processed at blocks 1010-1040 (e.g., during each repetition of blocks 1010-1040) at the various substrate placements are compiled. Referring to FIG. 13B, a graphical representation 1300B of the normalized etch rate profiles is shown. The normalized etch rate profiles 1352 may be representative of the etch rate profiles for substrates processed at each placement location 1102-118 shown in FIG. 11A and/or each placement location 1302 shown in FIG. 13A. Referring again to FIG. 10B, at block 1055, using the normalized etch rate profiles compiled at block 1050, a normalized etch rate at each azimuthal angle for each processed substrate is determined. Referring to FIG. 13B, a normalized etch rate is determined from a corresponding normalized etch rate profile 1352 at an azimuthal angle 1354. Azimuthal angle 1354 is illustrated at 45°. However, in some embodiments, several normalized etch rates for each processed substrate are determined from the normalized etch rate profiles 1352 at all azimuthal angles depending on how dense the substrate etch rate sampling map is.

Referring again to FIG. 10B, at block 1060, for each azimuthal angle for which normalized etch rates were determined at block 1055, a linear fitment is made. The linear fitment can be made using various linear and nonlinear higher order fitment methods known to those in the art. Referring to **FIG. 13A****,** an example plot diagram 1300A illustrating substrate placement in a DOE is shown. Substrates may be processed while placed at each of the substrate placement locations 1302 on the substrate support. A vector 1310 may correspond to azimuthal angle 1354 of FIG. 13B. The vector 1310 may be at an angle to the X-axis equivalent to the value of the azimuthal angle 1354. The placement locations 1302 may be projected onto vector 1310 and the location of each of the projected placement locations on the vector 1310 are translated to a value y'. As illustrated, y' is at an angle of 45° from the X axis of plot 1300A, and azimuthal angle 1354 is similarly at a corresponding angle theta of 45°. Referring to FIG. 13C, normalized etch rates 1372 at the azimuthal angle 1354 are shown with respect to dy'. A normalized etch rate 1372 is plotted for each of the processed substrates. A linear fit 1380 is calculated to fit the plotted normalized etch rates 1372. The process of projecting placement locations 1302 onto a vector 1310, translating the location of each of the projected placement locations onto the vector 1310 to y', and plotting normalized etch rates 1372 with respect to dy' may be repeated for each of the data corresponding to each of the several azimuthal angles.

Referring again to FIG. 10B, at block 1070, using one or more linear fitments calculated at block 1060, a predicted etch rate profile is calculated for an estimated substrate placement location. For example, using etch rate data and/or the linear fitments, an estimated location may be determined that may produce a substrate meeting one or more threshold criterion. The threshold criterion may include a threshold etch rate profile range, a threshold etch rate profile minimum, a threshold etch rate profile maximum, and/or a threshold etch rate profile standard deviation. A predicted value of etch rate at a specific azimuthal angle can be calculated for an estimated substrate placement location using the linear fit 1380 corresponding to the specific azimuthal angle. Once predicted etch rates at all azimuthal angles are determined, the predicted etch rates can be combined to form a predicted etch rate profile. At block 1080, an optimal substrate placement location to produce an optimized etch rate profile is determined. In some embodiments, processing logic searches all substrate placement locations to determine which location has the optimal etch rate profile (e.g., meeting one or more threshold criterion described above). The optimal placement location may be determined by experimentation. In some embodiments, a machine learning model as described herein may be used to determine the optimal placement location. The machine learning model may be trained with historical data such as historical etch rate profiles and/or historical substrate placement locations to determine an optimal placement to produce a substrate having an optimized etch rate profile. At block 1090, a substrate may be placed at the optimal placement location for processing.

Referring again to **FIG. 12A****,** an example plot 1200A of substrate etch rates with respect to azimuthal angle theta is shown, according to aspects of the present disclosure. In some embodiments, etch rate profile 1202A is the etch rate profile of a substrate processed at an optimal location on a substrate support. The optimal location may be determined using one or more methods described herein. In contrast, etch rate profile 1204A is the etch rate profile of a substrate processed at a non-optimal location on a substrate support.

Referring to **FIG. 12B****,** an example plot 1200B of normalized etch rates with respect to azimuthal angle theta is shown, according to aspects of the present disclosure. In some embodiments, normalized etch rate profile 1202B is the normalized etch rate profile of a substrate processed at an optimal location on a substrate support. In contrast, normalized etch rate profile 1204B is the normalized etch rate profile of a substrate processed at a non-optimal location on a substrate support. As shown by plot 1200B, the normalized etch rate profile 1202B has a more consistent normalized etch rate across all azimuthal angles theta. Therefore, the etch rates of the substrate processed at the optimal location are more consistent and processing substrates at the optimal location will yield better substrates than processing substrates at non-optimal locations.

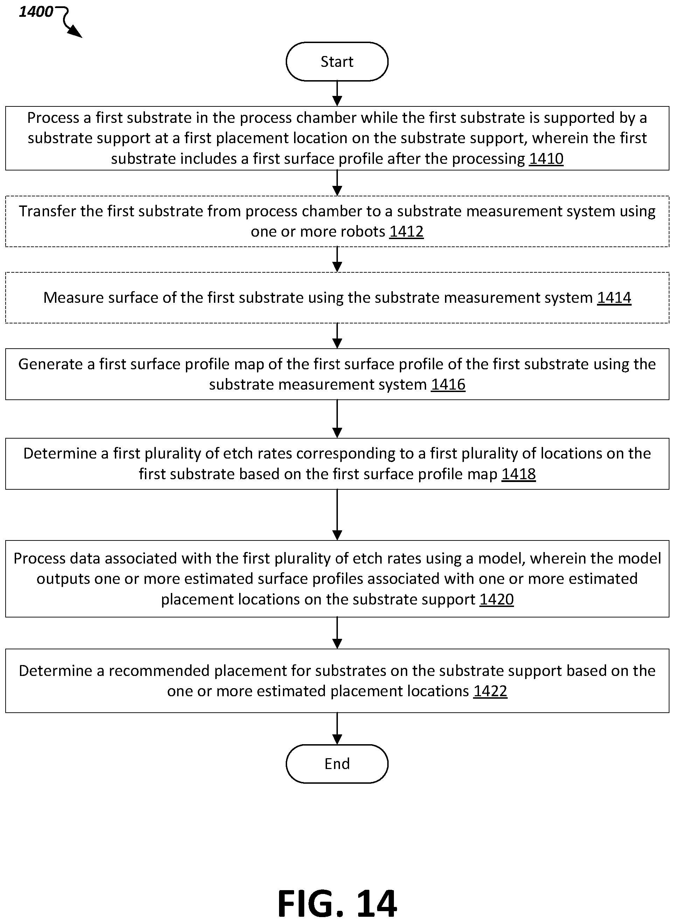

**FIG. 14** is a flow diagram for a method 1400 of determining an optimal substrate placement, according to aspects of the present disclosure. Method 1400 may be performed by processing logic that can include hardware (circuitry, dedicated logic, etc.), software (such as is run on a general purpose computer system or a dedicated machine), firmware, or some combination thereof. In one implementation, method 1400 can be performed by a computer system, such as computer system architecture 100 of FIG. 1. In other or similar implementations, one or more operations of method 1400 can be performed by one or more other machines not depicted in the figures.

At block 1410, a first substrate is processed in a process chamber. For example, the process chamber may perform an etch process to partially remove a film on the surface of the substrate or a film deposition process to deposit a film on the substrate. In some embodiments, the film is a polymer. In other embodiments, the film is a ceramic (e.g., a metal oxide). The processing of the substrate may be performed according to a recipe (e.g., an etch process recipe, a deposition process recipe, etc.). During the processing, the substrate may be supported by a substrate support of the process chamber (e.g., an electrostatic chuck). The substrate may be placed at an initial position in the process chamber prior to the processing and may remain in the initial position during the processing. After the processing, in some embodiments, the substrate includes a surface profile (e.g., a thickness profile, etc.).

At block 1412, one or more robots transfers the substrate from the process chamber to a substrate measurement system. If the substrate measurement system is connected to or included in a transfer chamber, then a transfer chamber robot may remove the substrate from the process chamber and insert the substrate into the substrate measurement system. If the substrate measurement system is connected to or included in a factory interface, then a transfer chamber robot may remove the substrate from the process chamber and place the substrate in a load lock. A factory interface robot may then remove the substrate from the load lock and insert the substrate into the substrate measurement system. The substrate measurement system may be any of the aforementioned substrate measurement systems, such as an integrated reflectometry (IR) device.

At block 1414, the substrate measurement system generates measurements for many locations on a surface of the substrate. Each location may have a unique set of coordinates.

At block 1416, the substrate measurement system and/or a computing device may generate a profile map of the surface profile of the substrate (e.g., a substrate surface profile map) based on the measurements of the substrate measurement system. The profile map may be or include an image, where each pixel in the image corresponds to a coordinate on the substrate. Each pixel may have an intensity value that corresponds to a measurement value (e.g., thickness value) at the coordinate of the substrate associated with the pixel. In some embodiments, the profile map is indicative of a thickness profile, which is indicative of an etch rate profile. For example, the profile map may reflect a thickness profile of the substrate having undergone an etch process for a predetermined amount of time. In some embodiments, the profile map is indicative of substrate surface defects such as tilt. Tilt is correlated to etch rate, in some embodiments. In some embodiments, the profile may be or include a feature vector, where each entry in the feature vector is associated with a coordinate of the substrate, and where each entry may have a value that represents a value of the surface profile at the coordinate of the substrate. In some embodiments, the processing logic (e.g., of the measurement system and/or of the computing device) may determine an etch rate profile map corresponding to an etch rate proximate the edge of the substrate.

At block 1418, a computing device may determine a plurality of etch rates corresponding to a plurality of locations on the substrate. The computing device may use the surface profile map generated at block 1416 to determine an etch rate profile of etch rates near the edge of the substrate at several azimuthal angles about the center of the substrate.

At block 1420, processing logic processes data associated with the plurality of etch rates determined at block 1418. In some embodiments, the computing device uses a model to process the data. The model may include a trained machine learning model, a mathematical model, a linear fitment model, and/or a statistical model. The model may output one or more estimated surface profiles associated with one or more estimated placement locations on the substrate support. For example, the model may use numerical methods to estimate a predicted surface profile for a substrate processed at an estimated placement location. In some embodiments, the model normalizes the etch rate profile (e.g., determined at block 1418) and determines a normalized etch rate a various values of azimuthal angle theta. In some embodiments, the model performs a linear fit using normalized etch rates from several processed substrate for each value of azimuthal angle theta. Using the linear fits, the model may determine one or more estimated placement locations on the substrate support for processing a substrate having an optimized etch rate profile.

At block 1422, processing logic (e.g., of the computing device) determines a recommended placement for substrates on the substrate support based on the one or more estimated placement locations (e.g., output by the model at block 1420). In some examples, the computing device may determine a location on the substrate support for placement of the substrate using the estimated placement locations. Specifically, the computing device may determine a coordinate position based or a value (or values) output from the model at block 1420. The processing logic may then cause another substrate to be placed in the process chamber (e.g., via a substrate-handling robot) according to the recommended placement as described herein.

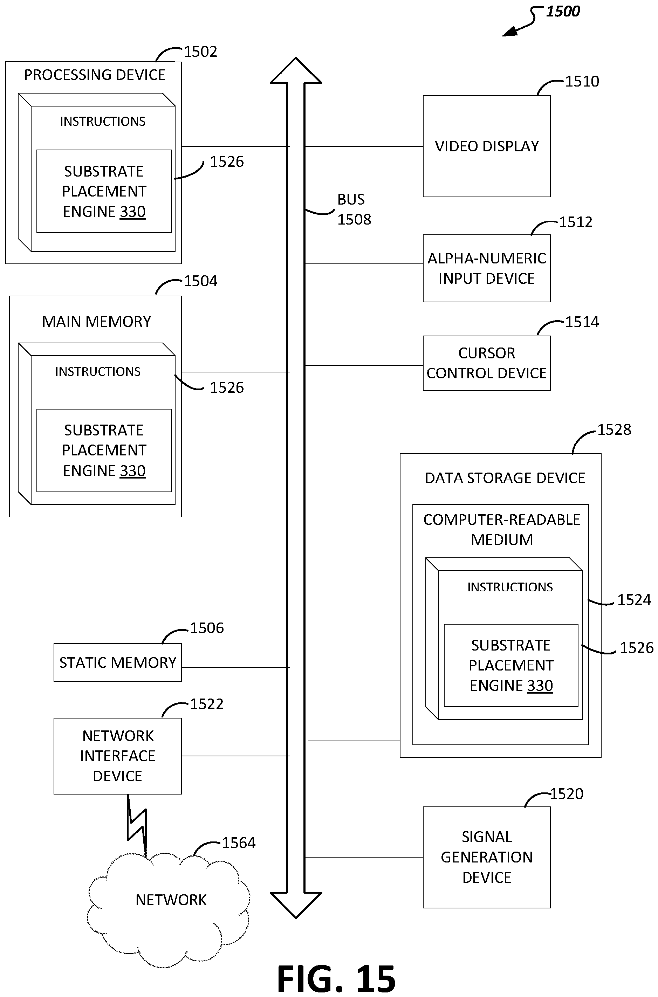

**FIG. 15** depicts a diagrammatic representation of a machine in the example form of a computing device 1500 within which a set of instructions, for causing the machine to perform any one or more of the methodologies discussed herein, can be executed. In alternative embodiments, the machine can be connected (e.g., networked) to other machines in a Local Area Network (LAN), an intranet, an extranet, or the Internet. The machine can operate in the capacity of a server or a client machine in a client-server network environment, or as a peer machine in a peer-to-peer (or distributed) network environment. The machine can be a personal computer (PC), a tablet computer, a set-top box (STB), a Personal Digital Assistant (PDA), a cellular telephone, a web appliance, a server, a network router, switch or bridge, or any machine capable of executing a set of instructions (sequential or otherwise) that specify actions to be taken by that machine. Further, while only a single machine is illustrated, the term "machine" shall also be taken to include any collection of machines (e.g., computers) that individually or jointly execute a set (or multiple sets) of instructions to perform any one or more of the methodologies discussed herein. In some embodiments, computing device 1500 can correspond to one or more of server machine 170, server machine 180, predictive server 112, system controller 228, server machine 320, or server machine 350, as described herein.

The example computing device 1500 includes a processing device 1502, a main memory 1504 (e.g., read-only memory (ROM), flash memory, dynamic random access memory (DRAM) such as synchronous DRAM (SDRAM), etc.), a static memory 1506 (e.g., flash memory, static random access memory (SRAM), etc.), and a secondary memory (e.g., a data storage device 1528), which communicate with each other via a bus 1508.

Processing device 1502 can represent one or more general-purpose processors such as a microprocessor, central processing unit, or the like. More particularly, the processing device 1502 can be a complex instruction set computing (CISC) microprocessor, reduced instruction set computing (RISC) microprocessor, very long instruction word (VLIW) microprocessor, processor implementing other instruction sets, or processors implementing a combination of instruction sets. Processing device 1502 can also be one or more special-purpose processing devices such as an application specific integrated circuit (ASIC), a field programmable gate array (FPGA), a digital signal processor (DSP), network processor, or the like. Processing device 1502 can also be or include a system on a chip (SoC), programmable logic controller (PLC), or other type of processing device. Processing device 1502 is configured to execute the processing logic for performing operations discussed herein.

The computing device 1500 can further include a network interface device 1522 for communicating with a network 1564. The computing device 1500 also can include a video display unit 1510 (e.g., a liquid crystal display (LCD) or a cathode ray tube (CRT)), an alphanumeric input device 1512 (e.g., a keyboard), a cursor control device 1514 (e.g., a mouse), and a signal generation device 1520 (e.g., a speaker).

The data storage device 1528 can include a machine-readable storage medium (or more specifically a non-transitory computer-readable storage medium) 1524 on which is stored one or more sets of instructions 1526 embodying any one or more of the methodologies or functions described herein. For example, instructions 1526 may include instructions for substrate placement engine 330. A non-transitory storage medium refers to a storage medium other than a carrier wave. The instructions 1526 can also reside, completely or at least partially, within the main memory 1504 and/or within the processing device 1502 during execution thereof by the computer device 1500, the main memory 1504 and the processing device 1502 also constituting computer-readable storage media.

While the computer-readable storage medium 1524 is shown in an example embodiment to be a single medium, the term "computer-readable storage medium" should be taken to include a single medium or multiple media (e.g., a centralized or distributed database, and/or associated caches and servers) that store the one or more sets of instructions. The term "computer-readable storage medium" shall also be taken to include any medium that is capable of storing or encoding a set of instructions for execution by the machine and that cause the machine to perform any one or more of the methodologies of the present disclosure. The term "computer-readable storage medium" shall accordingly be taken to include, but not be limited to, solid-state memories, and optical and magnetic media.

The preceding description sets forth numerous specific details such as examples of specific systems, components, methods, and so forth in order to provide a good understanding of several embodiments of the present disclosure. It will be apparent to one skilled in the art, however, that at least some embodiments of the present disclosure can be practiced without these specific details. In other instances, well-known components or methods are not described in detail or are presented in simple block diagram format in order to avoid unnecessarily obscuring the present disclosure. Thus, the specific details set forth are merely exemplary. Particular implementations can vary from these exemplary details and still be contemplated to be within the scope of the present disclosure.

Reference throughout this specification to "one embodiment" or "an embodiment" means that a particular feature, structure, or characteristic described in connection with the embodiment is included in at least one embodiment. Thus, the appearances of the phrase "in one embodiment" or "in an embodiment" in various places throughout this specification are not necessarily all referring to the same embodiment. In addition, the term "or" is intended to mean an inclusive "or" rather than an exclusive "or." When the term "about" or "approximately" is used herein, this is intended to mean that the nominal value presented is precise within ± 10%.

Although the operations of the methods herein are shown and described in a particular order, the order of operations of each method can be altered so that certain operations can be performed in an inverse order so that certain operations can be performed, at least in part, concurrently with other operations. In another embodiment, instructions or sub-operations of distinct operations can be in an intermittent and/or alternating manner.

The present disclosure provides, among others, the following embodiments, which are listed below
Embodiment 1. A method comprising: processing a first substrate in a process chamber of a substrate processing system according to a recipe while the first substrate is supported by a substrate support of the process chamber, wherein the first substrate comprises a first surface profile after the processing; generating a first profile map of the first surface profile of the first substrate using a substrate measurement system of the substrate processing system; processing data from the first profile map using a model, wherein the model outputs a first estimated substrate placement value for a placement of the first substrate relative to one or more components of the substrate support; and determining a recommended placement for substrates on the substrate support based on the first estimated substrate placement value.
Embodiment 2. The method of embodiment 1, further comprising: causing a second substrate to be placed in the process chamber according to the recommended placement, wherein the one or more components of the substrate support comprise a process kit ring, and wherein the second substrate is positioned within an inner diameter of the process kit ring in accordance with the recommended placement.
Embodiment 3. The method of embodiment 2, further comprising: processing the second substrate in the process chamber according to the recipe, wherein the second substrate comprises a second surface profile after the processing; generating a second profile map of the second surface profile using the substrate measurement system of the substrate processing system; processing data from the second profile map using the model, wherein the model outputs a second estimated substrate placement value; comparing the second estimated substrate placement value with the first estimated substrate placement value; and updating the recommended placement based on the comparing.
Embodiment 4. The method of embodiment 1, further comprising: determining a center of the substrate support; and aligning the first substrate with the center of the substrate support prior to the processing of the first substrate.
Embodiment 5. The method of embodiment 4, wherein for the recommended placement for the substrates a center of the substrates is offset from the center of the substrate support.
Embodiment 6. The method of embodiment 1, further comprising: determining a substrate handoff offset based on the recommended placement, wherein the substrate handoff offset is an offset for a robot arm from a first robot handoff orientation to a second robot handoff orientation.
Embodiment 7. The method of embodiment 1, wherein the first surface profile comprises a first thickness profile.
Embodiment 8. The method of embodiment 1, further comprising:
   determining a first etch rate profile of the first substrate for an etch rate profile proximate an edge of the first substrate based on the first profile map, wherein the model outputs the first estimated substrate placement value based on the first etch rate profile.
Embodiment 9. The method of embodiment 1, wherein the model comprises at least one of a trained machine learning model, a physics-based model, or a statistical model.
Embodiment 10. The method of embodiment 1, wherein the model comprises a trained machine learning model, the method further comprising:
   training a machine learning model to produce the trained machine learning model, wherein the machine learning model is trained using data from a plurality of processed substrates processed according to the recipe.
Embodiment 11. A system comprising: a process chamber; a substrate measurement tool; a memory; and a processing device coupled to the memory, the processing device to: cause a first substrate to be processed in the process chamber according to a recipe while the first substrate is supported by a substrate support of the process chamber, wherein the first substrate comprises a first surface profile after the processing; generate a first profile map of the first surface profile of the first substrate using the substrate measurement tool; process data from the first profile map using a model, wherein the model outputs a first estimated substrate placement value for a placement of the first substrate relative to one or more components of the substrate support; and determine a recommended placement for substrates on the substrate support based on the first estimated substrate placement value.
Embodiment 12. The system of embodiment 11, wherein the processing device is further to: cause a second substrate to be placed in the process chamber according to the recommended placement, wherein the one or more components of the substrate support comprise a process kit ring, and wherein the second substrate is positioned within an inner diameter of the process kit ring in accordance with the recommended placement.
Embodiment 13. The system of embodiment 12, wherein the processing device is further to: cause the second substrate to be processed in the process chamber according to the recipe, wherein the second substrate comprises a second surface profile after the processing;
   generate a second profile map of the second surface profile using the substrate measurement tool; process data from the second profile map using the model, wherein the model outputs a second estimated substrate placement value; compare the second estimated substrate placement value with the first estimated substrate placement value; and update the recommended placement based on the comparing.
Embodiment 14. The system of embodiment 11 wherein the processing device is further to: determine a center of the substrate support; and cause the first substrate to be aligned with the center of the substrate support prior to the processing of the first substrate.
Embodiment 15. The system of embodiment 11, wherein for the recommended placement for the substrates a center of the substrates is offset from the center of the substrate support.
Embodiment 16. The system of embodiment 11, wherein the model comprises a trained machine learning model, and wherein the processing device is further to: train a machine learning model to produce the trained machine learning model, wherein the machine learning model is trained using data from a plurality of processed substrates processed according to the recipe.
Embodiment 17. A computer readable medium comprising instructions that, when executed by a processing device, cause the processing device to perform operations comprising: causing a first substrate to be processed in a process chamber according to a recipe while the first substrate is supported by a substrate support of the process chamber, wherein the first substrate comprises a first surface profile after the processing; generating a first profile map of the first surface profile of the first substrate using a substrate measurement system of a substrate processing system; processing data from the first profile map using a model, wherein the model outputs a first estimated substrate placement value for a placement of the first substrate relative to one or more components of the substrate support; and determining a recommended placement for substrates on the substrate support based on the first estimated substrate placement value.
Embodiment 18. The computer readable medium of embodiment 17, the operations further comprising: causing a second substrate to be placed in the process chamber according to the recommended placement, wherein the one or more components of the substrate support comprise a process kit ring, and wherein the second substrate is positioned within an inner diameter of the process kit ring in accordance with the recommended placement.
Embodiment 19. The computer readable medium of embodiment 18, the operations further comprising: causing the second substrate to be processed in the process chamber according to the recipe, wherein the second substrate comprises a second surface profile after the processing; generating a second profile map of the second surface profile using the substrate measurement system; processing data from the second profile map using the model, wherein the model outputs a second estimated substrate placement value;
   comparing the second estimated substrate placement value with the first estimated substrate placement value; and updating the recommended placement based on the comparing.
Embodiment 20. The computer readable medium of embodiment 17, wherein the model comprises a trained machine learning model, the operations further comprising:
   training a machine learning model to produce the trained machine learning model, wherein the machine learning model is trained using data from a plurality of processed substrates processed according to the recipe.
Embodiment 21. A computer readable medium comprising instructions that, when executed by a processing device, cause the processing device to perform operations comprising: processing a first substrate in a process chamber of a substrate processing system while the first substrate is supported by a substrate support at a first placement location on the substrate support, wherein the first substrate comprises a first surface profile after the processing; generating a first surface profile map of the first surface profile using a substrate measurement system; determining a first plurality of etch rates corresponding to a first plurality of locations on the first substrate based on the first surface profile map; processing data associated with the first plurality of etch rates using a model, wherein the model is to output one or more estimated surface profiles associated with one or more estimated placement locations on the substrate support based on the first plurality of etch rates; and determining a recommended placement for substrates on the substrate support based on the one or more estimated placement locations.
Embodiment 22. The computer readable medium of embodiment 21, the operations further comprising: causing a second substrate to be placed in the process chamber on the substrate support according to the recommended placement within an inner diameter of a process kit ring.
Embodiment 23. The computer readable medium of embodiment 21, the operations further comprising: processing a second substrate in the process chamber while the second substrate is supported by the substrate support at a second placement location on the substrate support, wherein the second substrate comprises a second surface profile after the processing; generating a second surface profile map of the second surface profile using the substrate measurement system; determining a second plurality of etch rates corresponding to a second plurality of locations on the second substrate based on the second surface profile map; and processing data associated with the second plurality of etch rates using the model, wherein the one or more estimated surface profiles associated with the one or more estimated placement locations on the substrate support are further based on the second plurality of etch rates.
Embodiment 24. The computer readable medium of embodiment 21, wherein the recommended placement is offset from a center of the substrate support.
Embodiment 25. The computer readable medium of embodiment 21, wherein the model comprises at least one of a trained machine learning model, a linear fitment model, or a statistical model.
Embodiment 26. The computer readable medium of embodiment 25, wherein the model comprises the trained machine learning model, the operations further comprising: training a machine learning model to produce the trained machine learning model, wherein the machine learning model is trained using data from a plurality of processed substrates processed in the process chamber.
Embodiment 27. The computer readable medium of embodiment 21, wherein the first plurality of locations on the first substrate correspond to locations at a radial distance from a center of the first substrate at a plurality of azimuthal angles.
Embodiment 28. The computer readable medium of embodiment 21, wherein processing data associated with the first plurality of etch rates comprises generating a linear fitment of at least a first etch rate of the first plurality of etch rates corresponding to at least a first location of the first plurality of locations, and wherein the one or more estimated surface profiles are based on the linear fitment.
Embodiment 29. The computer readable medium of embodiment 21, wherein processing data associated with the first plurality of etch rates comprises normalizing each of the first plurality of etch rates based on an average etch rate of the first plurality of etch rates.
Embodiment 30. The computer readable medium of embodiment 21, wherein the recommended placement corresponds to an optimized placement location on the substrate support for producing a second substrate having a second plurality of etch rates at a second plurality of locations on the second substrate conforming to one or more values of one or more metrics.
Embodiment 31. The computer readable medium of embodiment 21, wherein the first surface profile comprises a first thickness profile.
Embodiment 32. A system comprising: a process chamber comprising a substrate support; a substrate measurement tool; a memory; and a processing device operatively coupled to the memory, the processing device to: cause a first substrate to be processed in the process chamber while the first substrate is supported by the substrate support at a first placement location on the substrate support, wherein the first substrate comprises a first surface profile after the processing; generate a first surface profile map of the first surface profile using the substrate measurement tool; determine a first plurality of etch rates corresponding to a first plurality of locations on the first substrate based on the first surface profile map; process data associated with the first plurality of etch rates using a model, wherein the model is to output one or more estimated surface profiles associated with one or more estimated placement locations on the substrate support based on the first plurality of etch rates; and determine a recommended placement for substrates on the substrate support based on the one or more estimated placement locations.
Embodiment 33. The system of embodiment 32, wherein the processing device is further to: cause a second substrate to be placed in the process chamber on the substrate support according to the recommended placement within an inner diameter of a process kit ring.
Embodiment 34. The system of embodiment 32, wherein the processing device is further to: cause a second substrate to be processed in the process chamber while the second substrate is supported by the substrate support at a second placement location on the substrate support, wherein the second substrate comprises a second surface profile after the processing; generate a second surface profile map of the second surface profile using the substrate measurement tool; determine a second plurality of etch rates corresponding to a second plurality of locations on the second substrate based on the second surface profile map; and process data associated with the second plurality of etch rates using the model, wherein the one or more estimated surface profiles associated with the one or more estimated placement locations on the substrate support are further based on the second plurality of etch rates.
Embodiment 35. The system of embodiment 32, wherein the model comprises a trained machine learning model, the processing device further to: train a machine learning model to produce the trained machine learning model, wherein the machine learning model is trained using data from a plurality of processed substrates processed in the process chamber.
Embodiment 36. The system of embodiment 32, wherein processing data associated with the first plurality of etch rates comprises: normalizing each of the first plurality of etch rates based on an average etch rate of the first plurality of etch rates; and generating a linear fitment of at least a first etch rate of the first plurality of etch rates corresponding to at least a first location of the first plurality of locations, wherein the one or more estimated surface profiles are based on the linear fitment.
Embodiment 37. The system of embodiment 32, wherein the recommended placement corresponds to an optimized placement location on the substrate support for producing a second substrate having a second plurality of etch rates at a second plurality of locations on the second substrate conforming to one or more values of one or more metrics.
Embodiment 38. A method comprising: causing a first substrate to be processed in a process chamber while the first substrate is supported by a substrate support at a first placement location on the substrate support, wherein the first substrate comprises a first surface profile after the processing; generating a first surface profile map of the first surface profile using a substrate measurement system; determining a first plurality of etch rates corresponding to a first plurality of locations on the first substrate based on the first surface profile map; processing data associated with the first plurality of etch rates using a model, wherein the model is to output one or more estimated surface profiles associated with one or more estimated placement locations on the substrate support based on the first plurality of etch rates; and determining a recommended placement for substrates on the substrate support based on the one or more estimated placement locations.
Embodiment 39. The method of embodiment 38, further comprising: causing a second substrate to be placed in the process chamber on the substrate support according to the recommended placement within an inner diameter of a process kit ring.
Embodiment 40. The method of embodiment 38, wherein processing data associated with the first plurality of etch rates comprises generating a linear fitment of at least a first etch rate of the first plurality of etch rates corresponding to at least a first location of the first plurality of locations, and wherein the one or more estimated surface profiles are based on the linear fitment.

It is understood that the above description is intended to be illustrative, and not restrictive. Many other embodiments will be apparent to those of skill in the art upon reading and understanding the above description. The scope of the disclosure should, therefore, be determined with reference to the appended claims, along with the full scope of equivalents to which such claims are entitled.

## Claims

1. A method comprising:
causing a first substrate to be processed in a process chamber while the first substrate is supported by a substrate support at a first placement location on the substrate support, wherein the first substrate comprises a first surface profile after the processing;
generating a first surface profile map of the first surface profile using a substrate measurement system;
determining a first plurality of etch rates corresponding to a first plurality of locations on the first substrate based on the first surface profile map;
processing data associated with the first plurality of etch rates using a model, wherein the model is to output one or more estimated surface profiles associated with one or more estimated placement locations on the substrate support based on the first plurality of etch rates; and
determining a recommended placement for substrates on the substrate support based on the one or more estimated placement locations.

2. The method of claim 1, further comprising:
causing a second substrate to be placed in the process chamber on the substrate support according to the recommended placement within an inner diameter of a process kit ring.

3. The method of claim 1, wherein processing data associated with the first plurality of etch rates comprises generating a linear fitment of at least a first etch rate of the first plurality of etch rates corresponding to at least a first location of the first plurality of locations, and wherein the one or more estimated surface profiles are based on the linear fitment.

4. A computer readable medium comprising instructions that, when executed by a processing device, cause the processing device to perform operations comprising a method of any of claims 1 to 3.

5. The computer readable medium of claim 4, the operations further comprising:
processing a second substrate in the process chamber while the second substrate is supported by the substrate support at a second placement location on the substrate support, wherein the second substrate comprises a second surface profile after the processing;
generating a second surface profile map of the second surface profile using the substrate measurement system;
determining a second plurality of etch rates corresponding to a second plurality of locations on the second substrate based on the second surface profile map; and
processing data associated with the second plurality of etch rates using the model, wherein the one or more estimated surface profiles associated with the one or more estimated placement locations on the substrate support are further based on the second plurality of etch rates.

6. The computer readable medium of claim 4, wherein the recommended placement is offset from a center of the substrate support or wherein the recommended placement corresponds to an optimized placement location on the substrate support for producing a second substrate having a second plurality of etch rates at a second plurality of locations on the second substrate conforming to one or more values of one or more metrics.

7. The computer readable medium of claim 4, wherein the model comprises at least one of a trained machine learning model, a linear fitment model, or a statistical model.

8. The computer readable medium of claim 7, wherein the model comprises the trained machine learning model, the operations further comprising:
training a machine learning model to produce the trained machine learning model, wherein the machine learning model is trained using data from a plurality of processed substrates processed in the process chamber.

9. The computer readable medium of claim 4, wherein the first plurality of locations on the first substrate correspond to locations at a radial distance from a center of the first substrate at a plurality of azimuthal angles.

10. The computer readable medium of claim 4, wherein processing data associated with the first plurality of etch rates comprises normalizing each of the first plurality of etch rates based on an average etch rate of the first plurality of etch rates.

11. The computer readable medium of claim 4, wherein the first surface profile comprises a first thickness profile.

12. A system comprising:
a process chamber comprising a substrate support;
a substrate measurement tool;
a memory; and
a processing device operatively coupled to the memory, the processing device to:
cause a first substrate to be processed in the process chamber while the first substrate is supported by the substrate support at a first placement location on the substrate support, wherein the first substrate comprises a first surface profile after the processing;
generate a first surface profile map of the first surface profile using the substrate measurement tool;
determine a first plurality of etch rates corresponding to a first plurality of locations on the first substrate based on the first surface profile map;
process data associated with the first plurality of etch rates using a model,
wherein the model is to output one or more estimated surface profiles associated with one or more estimated placement locations on the substrate support based on the first plurality of etch rates; and
determine a recommended placement for substrates on the substrate support based on the one or more estimated placement locations.

13. The system of claim 12, wherein the processing device is further to:
cause a second substrate to be placed in the process chamber on the substrate support according to the recommended placement within an inner diameter of a process kit ring, or wherein the processing device is further to:
cause a second substrate to be processed in the process chamber while the second substrate is supported by the substrate support at a second placement location on the substrate support, wherein the second substrate comprises a second surface profile after the processing;
generate a second surface profile map of the second surface profile using the substrate measurement tool;
determine a second plurality of etch rates corresponding to a second plurality of locations on the second substrate based on the second surface profile map; and
process data associated with the second plurality of etch rates using the model, wherein the one or more estimated surface profiles associated with the one or more estimated placement locations on the substrate support are further based on the second plurality of etch rates.

14. The system of claim 12, wherein the model comprises a trained machine learning model, the processing device further to:
train a machine learning model to produce the trained machine learning model, wherein the machine learning model is trained using data from a plurality of processed substrates processed in the process chamber.

15. The system of claim 12, wherein processing data associated with the first plurality of etch rates comprises:
normalizing each of the first plurality of etch rates based on an average etch rate of the first plurality of etch rates; and
generating a linear fitment of at least a first etch rate of the first plurality of etch rates corresponding to at least a first location of the first plurality of locations, wherein the one or more estimated surface profiles are based on the linear fitment.

16. The system of claim 12, wherein the recommended placement corresponds to an optimized placement location on the substrate support for producing a second substrate having a second plurality of etch rates at a second plurality of locations on the second substrate conforming to one or more values of one or more metrics.
